# EUROPÄISCHE PATENTSCHRIFT

(11) **EP 2 612 350 B1**
(45) Veröffentlichungstag und Bekanntmachung des Hinweises auf die Patenterteilung: **24.09.2014**
(21) Anmeldenummer: 11758123.1
(22) Anmeldetag: 29.08.2011
(51) Int. Cl.: H01L 21/67, H05K 3/12, H01L 31/0224

(54) **VERFAHREN UND VORRICHTUNG ZUR HERSTELLUNG EINER METALLISCHEN KONTAKTSTRUKTUR ZUR ELEKTRISCHEN KONTAKTIERUNG EINER PHOTOVOLTAISCHEN SOLARZELLE**
METHOD AND APPARATUS FOR PRODUCING A METALLIC STRUCTURE FOR A ELECTRICAL CONTACT OF A PHOTOVOLTAIC SOLAR CELL
PROCÉDÉ ET APPAREIL POUR PRODUIRE UNE STRUCTURE MÉTALLIQUE POUR LE CONTACT ÉLECTRIQUE D'UNE CELLULE SOLAIRE PHOTOVOLTAÏQUE

(30) Priorität: 03.09.2010 DE 102010044349
(43) Veröffentlichungstag der Anmeldung: 10.07.2013
(73) Patentinhaber: Fraunhofer-Gesellschaft zur Förderung der angewandten Forschung e.V., 80686 München (DE)
(72) Erfinder: BIRO, Daniel, 79106 Freiburg (DE); SPECHT, Jan, 79106 Freiburg (DE); SCHEFFLER, Daniel, 79106 Freiburg (DE); POSPISCHIL, Maximilian, 79108 Freiburg (DE); CLEMENT, Florian, 79102 Freiburg (DE)
(86) Internationale Anmeldenummer: PCT/EP2011/004323
(87) Internationale Veröffentlichungsnummer: WO 2012/028289

(56) Entgegenhaltungen:
- EP-A2- 1 787 785
- US-A- 5 151 377
- US-A1- 2007 169 806

## Beschreibung

Die Erfindung betrifft eine Vorrichtung und ein Verfahren zur Herstellung einer metallischen Kontaktstruktur zur elektrischen Kontaktierung einer photovoltaischen Solarzelle gemäß den Oberbegriffen der Ansprüche 1 und 7.

Eine photovoltaische Solarzelle stellt ein flächiges Halbleiterelement dar, bei dem mittels einfallender elektromagnetischer Strahlung eine Ladungsträgertrennung erzeugt wird, so dass zwischen mindestens zwei elektrischen Kontakten der Solarzelle ein Potential entsteht und über einen mit diesen Kontakten verbundenen externen Stromkreis elektrische Leistung von der Solarzelle abgegriffen werden kann.

Die Ladungsträger werden dabei über metallische Kontaktstrukturen eingesammelt, so dass durch Kontaktierung dieser Kontaktstrukturen an einem oder mehreren Kontaktpunkten die Ladungsträger in den externen Stromkreis eingespeist werden können. Typischerweise werden daher bei der Herstellung von Solarzellen metallische Kontaktstrukturen auf eine Oberfläche der Solarzelle aufgebracht, häufig in gitterartiger oder doppelkammartiger Form, wobei die Kontaktstrukturen die Oberfläche der Solarzelle fingerartig überdecken, so dass flächig aus allen Bereichen der Solarzelle die Ladungsträger durch die Kontaktstruktur eingesammelt werden und von dort einem externen Stromkreis zugeführt werden können.

Werden die Kontaktstrukturen auf einer Oberfläche der Solarzelle aufgebracht, an der elektromagnetische Strahlung in die Solarzelle eintreten soll, so müssen die Kontaktstrukturen konkurrierenden Anforderungen genügen: Die Kontaktstruktur soll einen möglichst kleinen Flächenbereich der Oberfläche der Solarzelle abdecken, um Abschattungsverluste zu minimieren. Weiterhin soll zur Vermeidung elektrischer Verluste die metallische Kontaktstruktur einen geringen Kontaktwiderstand zu dem kontaktierten Halbleiterbereich der Solarzelle aufweisen und andererseits soll der Leitungswiderstand innerhalb der Kontaktstruktur gering sein.

Es ist daher vorteilhaft, wenn die auf der Solarzelle angeordnete Kontaktierungsstruktur ein möglichst hohes Aspektverhältnis aufweist, d. h., dass das Verhältnis der Höhe zu der Breite der Kontaktstruktur groß ist. Die Kontaktstruktur ist in diesem Fall sehr schmal ausgebildet, so dass eine geringe Abschattung erzielt wird. Gleichzeitig ist die Kontaktstruktur sehr hoch ausgebildet, so dass die Querschnittsfläche groß ist, entsprechend der elektrische Leitungswiderstand senkrecht zur Querschnittsfläche gering und damit Ladungsträger verlustarm transportiert werden können.

Bekannt zur Herstellung solcher Kontaktstrukturen ist das vollständige Aufbringen der gesamten Kontaktstruktur in einem Schritt mittels Siebdruck einer silberhaltigen Paste. Hierbei entstehen jedoch breite Kontaktstrukturen, d. h., Kontaktstrukturen mit einem geringen Aspektverhältnis, die eine geringe Leitfähigkeit und wegen ihrer Breite auch verhältnismäßig hohe optische Verluste durch Abschattung des darunterliegenden Halbleitermaterials der Solarzelle verursachen.

Weiterhin ist es aus US 5,151,377 bekannt eine Kontaktstruktur zu erzeugen, in dem mittels eines Dispensers eine Paste, welche Metallpartikel enthält, über eine Ausgabeöffnung auf ein Halbleitersubstrat aufgetragen wird, wobei während der Ausgabe das Halbleitersubstrat relativ zu der Ausgabeöffnung bewegt wird.

Es wird ebenso Bezug genommen auf das Dokument US2007169806.

Für die industrielle Fertigung ist es wesentlich, dass der gesamte Herstellungsprozess der Solarzelle, insbesondere auch die Herstellung der Kontaktstruktur fehlerarm und kostengünstig durchgeführt werden kann, ohne das der Wirkungsgrad der Solarzelle durch das gewählte Herstellungsverfahren wesentlich beeinträchtigt wird.

Der vorliegenden Erfindung liegt daher die Aufgabe zugrunde, ein Verfahren und eine Vorrichtung zur Herstellung einer metallischen Kontaktstruktur zur elektrischen Kontaktierung einer photovoltaischen Solarzelle vorzuschlagen, welche industriell einsetzbar sind und insbesondere eine geringere Fehleranfälligkeit bzw. Ausfallrate gegenüber vorbekannten Verfahren und Vorrichtungen aufweisen. Weiterhin sollen mittels des erfindungsgemäßen Verfahrens und der erfindungsgemäßen Vorrichtung Kontaktstrukturen mit einem größerem Aspektverhältnis, verglichen mit herkömmlichen Siebdruckverfahren herstellbar sein.

Gelöst ist diese Aufgabe durch ein Verfahren zur Herstellung einer metallischen Kontaktstruktur zur elektrischen Kontaktierung einer photovoltaischen Solarzelle gemäß Anspruch 1 sowie durch eine entsprechende Vorrichtung gemäß Anspruch 11. Vorteilhafte Weiterbildungen des erfindungsgemäßen Verfahrens finden sich in den Ansprüchen 2 bis 10, vorteilhafte Weiterbildungen der erfindungsgemäßen Vorrichtung finden sich in den Ansprüchen 12 bis 21.

Bei dem erfindungsgemäßen Verfahren zur Herstellung einer metallischen Kontaktstruktur zur elektrischen Kontaktierung einer photovoltaischen Solarzelle wird zur Erzeugung der Kontaktierungsstruktur eine Paste, welche Metallpartikel enthält, über mindestens eine Ausgabeöffnung auf eine Oberfläche eines Trägersubstrates aufgebracht. Hierbei werden Ausgabeöffnung und Trägersubstrat relativ zueinander bewegt. Aufgrund der Relativbewegung ergibt sich somit auf dem Trägersubstrat eine Pastenbahn, aus der die Kontaktstruktur erzeugt wird.

Wesentlich ist, dass die Paste in einem Umwälzbereich umgewälzt wird und an einer Mehrzahl von Abzweigungen jeweils ein Teil der Paste aus dem Umwälzbereich abgezweigt wird. Jede Abzweigung ist hierbei mindestens einer Ausgabeöffnung zugeordnet, über welche die an der Abzweigung abgezweigte Paste auf die Oberfläche des Trägersubstrates aufgebracht wird. Weiterhin durchfließt die Paste jeweils zwischen Abzweigung aus dem Umwälzbereich und Ausgabe aus der der Abzweigung zugeordneten Ausgabeöffnung einen Flussweg mit einer Länge kleiner 5 cm.

Im Gegensatz zu vorbekannten Verfahren erfolgt somit eine Umwälzung der Paste in einem Umwälzbereich und lediglich ein Teil der Paste wird aus dem Umwälzbereich an einer Mehrzahl von Abzweigungen abgezweigt und über jeweils mindestens eine Ausgabeöffnung ausgegeben. Die Paste befindet sich somit in ständiger Bewegung, einerseits in dem Umwälzbereich oder bei Durchfließen der Abzweigung zu der Ausgabeöffnung. Dies ist in der Erkenntnis des Anmelders begründet, dass eine ständige Bewegung der Paste Ablagerungen und insbesondere Verstopfungen der Ausgabeöffnungen verhindert. Durch das erfindungsgemäße Verfahren wird somit die Fehleranfälligkeit insbesondere aufgrund von Ablagerungen und Verstopfungen gegenüber herkömmlichen Verfahren stark verringert. Hierzu ist es weiterhin nach Erkenntnis des Anmelders wesentlich, dass nur eine geringe Menge an Paste außerhalb des Umwälzbereich bewegt wird. Dies ist bei dem erfindungsgemäßen Verfahren dadurch gewährleistet, dass die Länge des Flussweges ausgehend von der Abzweigung zu der der Abzweigung zugeordneten Ausgabeöffnung kleiner 5 cm ist.

Durch die Mehrzahl von Abzweigungen können durch das erfindungsgemäße Verfahren gleichzeitig mehrere Pastenbahnen parallel nebeneinander auf dem Trägersubstrat erzeugt werden, so dass eine schnelle und somit industriell kostengünstig einsetzbare Herstellung der metallischen Kontaktstruktur erfolgt. Darüber hinaus ist es möglich, die Relativbewegung zwischen den Ausgabeöffnungen und dem Trägersubstrat derart zu wählen, bzw. die Ausgabeöffnungen derart anzuordnen, dass nachfolgend zwei oder mehrere Pastenbahnen übereinander auf das Trägersubstrat aufgebracht werden, so dass zusätzlich ein hohes Aspektverhältnis (Höhe zu Breite) der erzeugten Pastenbahn erzielt wird und somit eine für Solarzellen vorteilhafte Kontaktstruktur erzeugt wird, wie eingangs beschrieben.

Die vorgenannte Aufgabe ist weiterhin gelöst durch eine Vorrichtung gemäß Anspruch 11. Die erfindungsgemäße Vorrichtung zur Herstellung einer metallischen Kontaktierungsstruktur zur elektrischen Kontaktierung einer photovoltaischen Solarzelle umfasst mindestens einen Ausgabeflussweg mit einer Ausgabeöffnung für eine Paste, welche Metallpartikel enthält und mindestens ein Pumpmittel zur Ausgabe der Paste über den Ausgabeflussweg an der Ausgabeöffnung auf die Oberfläche eines Trägersubstrates. Mittels des Pumpmittels ist somit Paste über den Ausgabeflussweg aus der Ausgabeöffnung auf die Oberfläche des Trägersubstrates ausgebbar.

Wesentlich ist, dass die erfindungsgemäße Vorrichtung einen Umwälzbereich umfasst und dass Pumpmittel derart mit dem Umwälzbereich zusammenwirkend ausgebildet ist, dass die Paste in dem Umwälzbereich mittels des Pumpmittels umwälzbar ist. Der Umwälzbereich weist eine Mehrzahl von Abzweigungen auf, welche jeweils fluidleitend über mindestens einen Ausgabeflussweg mit mindestens einer Ausgabeöffnung verbunden sind, derart, dass an den Abzweigungen jeweils ein Teil der Paste aus dem Umwälzbereich abzweigbar und über die Ausgabeöffnungen auf das Trägersubstrat aufbringbar ist. Weiterhin ist die Länge des Flussweges der Paste ausgehend von der Abzweigung über die Ausgabeflusswege zu der Ausgabeöffnung jeweils kleiner 5 cm.

Auch bei der erfindungsgemäßen Vorrichtung ergeben sich somit die zuvor hinsichtlich des erfindungsgemäßen Verfahrens genannten Vorteile, da die Paste in dem Umwälzbereich umwälzbar ist und somit Fehler aufgrund von Ablagerungen oder Verstopfungen minimiert werden sowie dadurch, dass die vorgenannte Länge des Flussweges zwischen Abzweigung und Ausgabeöffnung kleiner 5 cm ist. Zur weiteren Verringerung des Risikos einer Verstopfung ist die Länge des Flussweges zwischen Abzweigung und Ausgabeöffnung vorzugsweise kleiner 1 cm, weiter bevorzugt kleiner 0,7 cm, bevorzugt kleiner 0,3 cm, im Weiteren bevorzugt kleiner 0,05 cm insbesondere kleiner 0,03 cm. Entsprechend ist die genannte Länge des Flussweges bei dem erfindungsgemäßen Verfahren vorzugsweise wie zuvor genannt gewählt.

Wesentlich für die Erfindung ist somit, dass in dem Umwälzbereich ein Umwälzen der Paste erfolgt und aus dem Umwälzbereich Paste über die Mehrzahl von Abzweigungen abgezweigt und über die jeweilige Ausgabeöffnung ausgegeben wird. Hierbei liegt es im Rahmen der Erfindung, dass das Umwälzen in dem Umwälzbereich kleinräumig wie beispielsweise durch Umrühren mittels eines Rührwerks erfolgt. Ebenfalls liegt es im Rahmen der Erfindung, dass das Unwälzen durch ein Hin- und Herbewegen der Paste in dem Umwälzbereich, insbesondere durch eine oszillierende Pastenbewegung erfolgt. In einer vorzugsweisen Ausführungsform wird die Paste mittels eines Pumpmittels bewegt, vorzugsweise in oszillierender Weise zumindest im Bereich der Mehrzahl von Abzweigungen. Dies ist beispielsweise in einer vorzugsweisen Ausführungsform realisierbar, in dem an einem oder an beiden Enden des Umwälzbereichs Pumpmittels vorgesehen sind, welche die Paste im Umwälzbereich hin- und herbewegen.

In einer weiteren vorzugsweisen Ausführungsform erfolgt das Umwälzen in dem Umwälzbereich durch Umwälzen der Paste in einem Umwälzkreislauf. Hierdurch ergibt sich der Vorteil, dass in einfacher Weise weitere Elemente, wie beispielsweise ein als Pastenspeicher dienender Behälter in den Umwälzkreislauf fluidtechnisch einbindbar sind.

Ebenso liegt es im Rahmen der Erfindung, beide Bewegungsarten zu kombinieren, dass heißt, einen Umwälzkreislauf vorzusehen, bei dem ständig oder zeitweise eine oszillierende Hin- und Herbewegung der Paste mittels des Pumpmittels zumindest im Umwälzbereich im Bereich der Mehrzahl von Abzweigungen erfolgt.

Die erfindungsgemäße Vorrichtung und das erfindungsgemäße Verfahren sind zur Verwendung beliebiger Pasten geeignet, insbesondere auch niedrigviskose Pasten. Besonders vorteilhaft ist die Verwendung Metallpartikel enthaltender Druckpasten.

Vorteilhafterweise wird bei dem erfindungsgemäßen Verfahren die Paste an allen Ausgabeöffnungen mit in etwa gleichem Volumenstrom ausgegeben. Hierdurch wird erzielt, dass die aus den verschiedenen Ausgabeöffnungen gleichzeitig auf das Trägersubstrat aufgebrachten Pastenbahnen gleiche Volumen, d. h., insbesondere gleiche Breite und Höhe quer zur Bewegungsrichtung besitzen, so dass eine einheitliche und mit hoher Wiederholungsgenauigkeit mehrfach herstellbare Kontaktstruktur erzeugt wird.

Vorteilhafterweise ist bei dem erfindungsgemäßen Verfahren der Volumenstrom im Umwälzbereich und/oder stromaufwärts der ersten Abzweigung mindestens um einen Faktor 5, vorzugsweise mindestens um einen Faktor 10, bevorzugt mindestens um einen Faktor 50, im Weiteren bevorzugt mindestens um einen Faktor 100, insbesondere mindestens um einen Faktor 1000 größer als die Summe der Volumenströme aller Ausgabeöffnungen. Hierdurch ist gewährleistet, dass ein erheblich größerer Teil an Paste im Umwälzbereich umgewälzt wird und nur ein demgegenüber geringer Teil über die Abzweigungen abgezweigt und die Ausgabeöffnungen ausgegeben wird. Es wird somit stets eine große Menge an Paste umgewälzt und die Bedingungen beim Umwälzen der Paste sind im Wesentlichen durch den Volumenstrom im Umwälzbereich vorgebbar und nahezu unabhängig von der entnommenen Paste. Hierdurch ist durch die Umwälzbedingung eine Umgebungsbedingung vorgebbar, die ein Anhaften der Paste verhindert.

Vorteilhafterweise liegt bei dem erfindungsgemäßen Verfahren in allen Teilbereichen des Umwälzbereiches, in denen sich eine Abzweigung zur Ausgabe von Paste über eine Ausgabeöffnung befindet, ein Druck von mindestens 3 bar, bevorzugt mindestens 5 bar, im Weiteren bevorzugt mindestens 10 bar, insbesondere mindestens 20 bar, weiter bevorzugt mindestens 30 bar über dem Umgebungsdruck vor. Hierdurch ist gewährleistet, dass eventuelle Druckunterschiede im Umwälzbereich aufgrund der Entnahme von Paste an den Abzweigungen nur zu einer relativ kleinen Druckänderung im Umwälzbereich führen und somit in etwa gleich bleibende Bedingungen an allen Abzweigungen vorliegen und ein gleicher Volumenstrom an allen Ausgabeöffnungen erzielbar ist.

Insbesondere ist es vorteilhaft, dass der Druck der Paste an den Abzweigungen um weniger als 5 %, vorzugsweise um weniger als 1 %, bevorzugt um weniger als 0,5 % differiert. Durch diese geringfügige Differenz des Drucks der Paste an den Abzweigungen untereinander ist ebenfalls die Ausgabe der Paste mit in etwa gleichem Volumenstrom an allen Ausgabeöffnungen gewährleistet.

Vorzugsweise wird bei dem erfindungsgemäßen Verfahren zumindest in einem Teilbereich des Flussweges des Umwälzbereiches Paste über mehrere in Fließrichtung der Paste hintereinander liegende Abzweigungen abgezweigt und ausgehend von jeder Abzweigung mindestens einer dieser Abzweigung zugeordneten Ausgabeöffnung zugeführt. Hierdurch ist in einfacher Weise die multiple Abzweigung und Ausgabe von Paste aus dem Umwälzbereich möglich. Entsprechend ist die erfindungsgemäße Vorrichtung vorteilhafterweise derart ausgeführt, dass mindestens in einem Teilbereich des Umwälzbereiches mehrere in Fließrichtung der Paste hintereinander liegende Abzweigungen angeordnet sind, welche jeweils fluidleitend über mindestens einen Ausgabeflussweg mit mindestens einer Ausgabeöffnung verbunden sind. Hierdurch ist in konstruktiv einfacher Weise die multiple Abzweigung und Ausgabe von Paste über die Ausgabeöffnungen realisiert.

Zur Erzielung der Ausgabe der Paste an den in Flussrichtung im Umwälzbereich hintereinander liegenden Ausgabeöffnungen mit in etwa gleichem Volumenstrom ist bei dem erfindungsgemäßen Verfahren bei den in Fließrichtung der Paste im Umwälzbereich hintereinander liegenden Abzweigungen der Gesamtdruckabfall von der in Fließrichtung ersten zu der in Fließrichtung letzten Abzweigung vorzugsweise um mindestens einen Faktor 10, bevorzugt mindestens einen Faktor 50, insbesondere um mindestens einen Faktor 100 geringer als der mittlere Druckabfall zwischen Abzweigung und der der Abzweigung zugeordnete Ausgabeöffnung. Aufgrund des in dieser vorteilhaften Ausführungsform wesentlich höheren Druckabfalls zwischen Abzweigung und Ausgabeöffnung verglichen mit dem Druckabfall der Abzweigungen untereinander herrschen somit in etwa gleiche Bedingungen an jeder Abzweigung vor, so dass in einfacher Weise eine Ausgabe von Paste mit gleichem Volumenstrom an jede Ausgabeöffnung realisierbar ist.

Die erfindungsgemäße Vorrichtung ist vorteilhafterweise derart ausgeführt, dass bei den mehreren in Fließrichtung der Paste im Umwälzbereich hintereinander liegenden Abzweigungen zwischen in Flussrichtung des Umwälzbereiches erster und letzter Abzweigung die minimale Querschnittsfläche des Umwälzbereiches mindestens um einen Faktor 5, vorzugsweise mindestens um einen Faktor 10, bevorzugt mindestens um einen Faktor 50, im Weiteren bevorzugt mindestens um einen Faktor 100, insbesondere mindestens um einen Faktor 1000 größer ist als die minimale Querschnittsfläche aller Flusswege zwischen einer Abzweigung und der dieser Abzweigung zugeordneten Ausgabeöffnung. Hierdurch ist gewährleistet, dass das Umwälzvolumen deutlich größer ist als das abgezweigte Volumen der Paste und es wird in einfacher Weise ein geringer Druckabfall zwischen in Flussrichtung des Umwälzbereiches erster und letzter Abzweigung realisiert, so dass eine Ausgabe von Paste mit in etwa gleichem Volumenstrom an allen Ausgabeöffnungen möglich ist.

Die Ausgabeöffnungen weisen vorteilhafterweise jeweils einen Öffnungsdurchmesser kleiner 200 µm, bevorzugt kleiner 150 µm, weiter bevorzugt kleiner 100 µm, im Besonderen bevorzugt kleiner 80 µm, weiter bevorzugt kleiner 50 µm, insbesondere bevorzugt kleiner 30 µm auf. Hierdurch wird eine exakte Pastenausgabe auf das Trägersubstrat ermöglicht. Insbesondere ist die erfindungsgemäße Vorrichtung vorzugsweise derart ausgeführt, dass bei jeder Ausgabeöffnung im Flussweg zwischen Abzweigung aus dem Umwälzbereich und Ausgabeöffnung der Leitungsdurchmesser kleiner 200 µm, bevorzugt kleiner 150 µm, weiter bevorzugt kleiner 100 µm, im Besonderen bevorzugt kleiner 80 µm, weiter bevorzugt kleiner 50 µm, insbesondere bevorzugt kleiner 30 µm ist. Hierdurch ergibt sich der Vorteil, dass die Paste ohne zusätzliche Scherung gerichtet und laminar durch die Öffnung die Vorrichtung verlässt und so einen gleichmäßigen Auftrag der Kontaktfinger auf das Substrat ermöglicht.

Um einen dennoch vorhandenen Druckabfall zwischen den in Flussrichtung des Umwälzbereiches hintereinander liegenden Abzweigungen zu kompensieren, ist die erfindungsgemäße Vorrichtung vorteilhafterweise derart ausgebildet, dass bei dem in Flussrichtung des Umwälzbereiches hintereinander liegenden Abzweigungen die Länge des Flussweges der Paste zwischen Abzweigung und Ausgabe aus der der Abzweigung zugeordneten Ausgabeöffnung in Fließrichtung des Umwälzbereiches abnimmt. Hierdurch verringert sich aufgrund der sich verkürzenden zu durchfließenden Länge der Durchflusswiderstand für die Paste zwischen Abzweigung und zugeordneter Ausgabeöffnung von der in Fließrichtung des Umwälzbereich ersten zu der in Fließrichtung des Umwälzbereich letzten Abzweigung hin, so dass ein Druckabfall an den Abzweigungen kompensiert wird. Zusätzlich oder alternativ ist es vorteilhaft, dass die minimale Querschnittsöffnung zwischen Abzweigung aus dem Umwälzbereich und Ausgabe aus der Ausgabeöffnung in Fließrichtung des Umwälzbereiches zunimmt. Auch hierdurch wird der Durchflusswiderstand für die Paste zwischen Abzweigung und Ausgabeöffnung ausgehend von der in Flussrichtung des Umwälzbereiches ersten Abzweigung zu der in Flussrichtung des Umwälzbereiches letzten Abzweigung somit verringert und kompensiert einen etwaigen Druckabfall. Vorzugsweise sind die Längen der Flusswege und/oder die Querschnitte derart gewählt, dass an allen Ausgabeöffnungen Paste mit in etwa gleichem Volumenstrom ausgebbar ist. Eine Änderung der Querschnitte der Ausgabeöffnungen führt jedoch zu einer Änderung der Linienbreite der aufgebrachten Pastenbahnen, so dass vorzugsweise die Querschnitte konstant sind und lediglich die Länge der Flusswege wie beschrieben in Flussrichtung abnehmend ausgebildet sind.

Sofern die Flusswege zwischen Abzweigung aus dem Umwälzbereich und Ausgabeöffnung variierende Querschnitte aufweisen, sind sie vorteilhafterweise derart ausgebildet, dass der engste Querschnitt an der Ausgabeöffnung vorliegt. Hierdurch wird vermieden, dass sich Paste bereits im Flussweg von den Leitungswänden löst und ungerichtet aus der Ausgabeöffnung austreten kann. Alternativ oder zusätzlich ist vorzugsweise der Flussweg zur Ausgabeöffnung jeweils als kegelförmige Düse ausgebildet. Hierdurch ergibt sich der Vorteil, dass die Reibung in den Düsen weitaus geringer ausfällt und so der Betriebsdruck der Vorrichtung gesenkt werden kann.

Vorzugsweise ist bei der erfindungsgemäßen Vorrichtung mit Ausbildung des Umwälzbereiches als Umwälzkreislauf das Pumpmittel stromaufwärts der Mehrzahl von Abzweigungen angeordnet und stromabwärts der in Flussrichtung letzten Abzweigung ist eine Drossel zur Erhöhung des Durchflusswiderstandes der Paste angeordnet. Hierdurch wird in einfacher Weise zwischen Pumpmittel und Drossel, d. h. an allen Abzweigungen, ein erhöhter Druck im Umwälzkreislauf realisiert, wohingegen stromabwärts der Drossel bis zum Widereintritt der Paste in die Pumpe im Umwälzkreislauf ein demgegenüber geringerer Druck, beispielsweise nahe dem Umgebungsdruck möglich ist. Hierdurch ergibt sich einerseits eine konstruktiv einfache Ausgestaltung, insbesondere ist vorzugsweise zwischen Drossel und Pumpmittel ein gegenüber der Umgebung offenes Reservoir stromabwärts der Drossel angeordnet, so dass einerseits in einfacher Weise Paste in großer Menge in den Umwälzkreislauf vorgehalten werden kann und andererseits das gegenüber dem Umgebungsdruck offene Reservoir in einfacher Weise auch während eines Verfahrensprozesses nachgefüllt werden kann. Vorzugsweise ist die Drossel als regelbare Drossel ausgebildet, so dass durch den Benutzer durch Regelung des Durchflusswiderstandes der Drossel der Druck zwischen Pumpmittel und Drossel regelbar ist.

Eine regelbare Drossel weist weiterhin den Vorteil auf, dass das Einstellen der optimalen Parameter zur Pastenausgabe (Druck, Volumenstrom etc.) durch Regelung der Pumpleistung und der Drosselwirkung genauer und gezielter einstellbar ist. Vorzugsweise ist bei der erfindungsgemäßen Vorrichtung im Bereich des Umwälzkreislaufes über den Ausgabeöffnungen eine Druckmessvorrichtung vorgesehen, zur Messung des Pastendrucks. Die Druckmessvorrichtung ist vorzugsweise derart ausgebildet, dass der Pastendruck über eine fluidundurchlässige Membran auf ein flüssiges Medium übertragen wird, und in dem flüssigen Medium ein Druckmessgerät angeordnet ist. Hierdurch wird ein Anhaften der Paste an dem Druckmessgerät verhindert.

Vorzugsweise umfasst die erfindungsgemäße Vorrichtung mindestens zwei Pumpmittel, wobei ein erstes Pumpmittel im Umwälzbereich stromaufwärts der ersten Abzweigung zu einer Ausgabeöffnung und ein zweites Pumpmittel stromabwärts der letzten Abzweigung zu einer Ausgabeöffnung im Umwälzbereich angeordnet ist. Beide Pumpmittel sind vorzugsweise als regelbare Pumpmittel ausgebildet. Durch Wahl der Fördermenge der beiden Pumpmittel lässt sich bei dieser vorzugsweisen Ausführungsform die Menge der über die Ausgabeöffnungen ausgegebenen Paste steuern: Wird die Fördergeschwindigkeit des zweiten Pumpmittels geringer als die des ersten gewählt, so wirkt das zweite Pumpmittel als eine Art Drossel, so dass ein Druckaufbau zwischen erstem und zweitem Pumpmittel erzielt wird und durch Erhöhung des Druckaufbaus, d. h. Erhöhung der Differenz in der Fördermenge der beiden Pumpmittel eine erhöhte Pastenausgabe an den Ausgabeöffnungen erzielt werden kann bzw. durch entsprechende Reduzierung die Pastenausgabe reduziert werden kann. Darüber hinaus weist das zweite Pumpmittel den Vorteil auf, dass auch die Förderung der Paste im Umwälzbereich nach den Abzweigungen zu dem Pastenreservoir hin aufgrund des zweiten Pumpmittels eine geringere Fehleranfälligkeit aufweist. Vorzugsweise weist die erfindungsgemäße Vorrichtung sowohl ein zweites Pumpmittel, wie zuvor beschrieben, als auch eine Drossel, wie zuvor beschrieben, auf, hierdurch ist eine sehr exakte Steuerung des Druckabfalls bzw. der Pastenausgabemenge an den Ausgabeöffnungen sowie der Flussgeschwindigkeiten im Umwälzbereich möglich.

Vorzugsweise umfasst die erfindungsgemäße Vorrichtung im Umwälzbereich mindestens eine Durchflussmessvorrichtung zum Messen der Fließgeschwindigkeit und/oder Durchflussmenge der Paste. Hierdurch ist eine Kontrolle des Umwälzvorgangs möglich, insbesondere eine Überprüfung oder, mittels Steuereinheit und entsprechender Steuerung der Pumpe, Regelung einer vorgegebenen Fließgeschwindigkeit im Umwälzbereich. Insbesondere ist es vorteilhaft, im Umwälzbereich vor der ersten Abzweigung und nach der letzten Abzweigung zu einer Ausgabeöffnung jeweils eine Durchflussmessvorrichtung vorzusehen. Hierdurch kann aus der Differenz der beiden Durchflussmessungen die Menge der ausgegebenen Paste bestimmt werden und insbesondere über eine Steuereinheit und entsprechende Steuerung der Pumpe und/oder einer regelbaren Drossel und/oder einer weiteren Pumpe die ausgegebene Menge auf einen vorgegebenen Wert geregelt werden.

Vorzugsweise sind bei der erfindungsgemäßen Vorrichtung im Umwälzbereich in Fließrichtung zwischen erster und letzter Abzweigung keine Pumpmittel zwischengeschaltet. Hierdurch wird eine etwaige durch die Pumpmittel bewirkte Druckveränderung, die zu unterschiedlichen Volumenströmen an den Ausgabeöffnungen führen könnte, vermieden.

Vorteilhafterweise ist bei der erfindungsgemäßen Vorrichtung der Umwälzbereich zumindest im Bereich der Abzweigungen als Hohlkörper mit mehreren als Ausnehmungen im Hohlkörper ausgebildeten Abzweigungen realisiert. Auf diese Weise sind in konstruktiv einfacher und damit kostengünstig herstellbarer Weise mehrere Abzweigungen und jede Abzweigung jeweils eine zugeordnete Ausgabeöffnung in Fließrichtung der Paste im Umwälzbereich hintereinander angeordnet. Insbesondere ist es vorteilhaft, dass die Ausnehmungen düsenförmig ausgebildet sind. Hierdurch können aus dem Stand der Technik zum Aufbringen von Paste vorbekannte Düsenformen in einfacher Weise übernommen werden, beispielsweise um vorteilhafte Aspektverhältnisse der Pastenbahn auf dem Trägersubstrat zu erzeugen.

Eine kostengünstige Ausführung der erfindungsgemäßen Vorrichtung ergibt sich, in dem der vorgenannte Hohlkörper sich im Umwälzbereich stromabwärts der letzten Abzweigung verjüngt, so dass durch diese Querschnittsverjüngung eine Drosselwirkung gegeben ist. Bei Ausbildung der erfindungsgemäßen Vorrichtung mit einer regelbaren Drossel wie zuvor beschrieben, kann eine solche Verjüngung zusätzlich vorgesehen sein, vorteilhafterweise wird in diesem Fall die Drosselung jedoch ausschließlich durch die regelbare Drossel gewährleistet, um eine hohe Variabilität zu gewährleisten. Die Querschnittsfläche des Hohlkörpers zumindest im Bereich der Abzweigungen beträgt vorzugsweise mindestens 0,3 mm², bevorzugt mindestens 1 mm², weiter bevorzugt mindestens 1,8 mm², im Weiteren bevorzugt mindestens 2,8 mm², im Weiteren bevorzugt mindestens 6 mm², um einen geringen Flusswiderstand im Umwälzbereich und eine ausreichende Pastenmenge im Umwälzbereich zu gewährleisten.

In einer weiteren vorzugsweisen Ausführungsform des erfindungsgemäßen Verfahrens wird die Paste im Umwälzbereich zumindest in einem Teilbereich über eine Verzweigung und stromabwärts der Verzweigung in mehreren parallelen Flusswegen umgewälzt, wobei in jedem der parallelen Flusswege mindestens an einer Abzweigung ein Teil der Paste abgezweigt und über mindestens eine der Abzweigung zugeordnete Ausgabeöffnung ausgegeben wird. Dies ist insbesondere vorteilhaft, um eine weitere Scherung und damit eine bessere Durchmischung und Verflüssigung der Paste zu verursachen.

Um die Fehleranfälligkeit durch Ablagerungen der Paste im Umwälzbereich oder Verstopfungen weiter zu minimieren, weist die erfindungsgemäße Vorrichtung zumindest im Bereich der Abzweigungen vorteilhafterweise eine oder mehrere Schwingungsvorrichtungen auf, die an dem Umwälzbereich angeordnet sind, um die Paste in Schwingung zu versetzen. Durch die Schwingungen wird die Gefahr einer Ablagerung oder Verstopfung weiter verringert. Insbesondere ist es vorteilhaft, die Schwingungsvorrichtung als Ultraschallgenerator zur Beaufschlagung der Paste mit Ultraschall auszubilden.

Vorzugsweise ist bei der erfindungsgemäßen Vorrichtung im Umwälzbereich eine Heizeinrichtung angeordnet, so dass mittels der Heizeinrichtung ein Wärmeeintrag in die umgewälzte Paste erzielbar ist. Hierdurch kann ein Erwärmen der umgewälzten Paste erfolgen, um die Viskosität der Paste zu senken. Insbesondere ist es vorteilhaft, an und/oder im Bereich der Ausgabeöffnungen eine oder mehrere Heizeinrichtungen vorzusehen, so dass die Paste zumindest an den Ausgabeöffnungen, vorteilhafterweise im Flussweg zwischen Abzweigungen und Ausgabeöffnungen mittels Wärmeeintrag beaufschlagbar ist, so dass durch Erwärmung und damit Senkung der Viskosität zusätzlich das Risiko von Verstopfungen insbesondere in dem kritischen Bereich zwischen Abzweigung und Ausgabeöffnung verringert wird.

Typischerweise erfolgt das Aufbringen der Paste mittels des erfindungsgemäßen Verfahrens bzw. der erfindungsgemäßen Vorrichtung auf ein Halbleitersubstrat zur Herstellung einer photovoltaischen Solarzelle. Ebenso liegt es im Rahmen der Erfindung, dass das Trägersubstrat ausgebildet ist, um mehrere Solarzellen, beispielsweise in Modulverschaltung, aufzunehmen. Es liegt somit insbesondere ebenso im Rahmen der Erfindung, mittels des erfindungsgemäßen Verfahrens bzw. der erfindungsgemäßen Vorrichtung eine Kontaktstruktur auf einem Trägersubstrat zu erzeugen, welches Teil eines Moduls zur Aufnahme mehrerer photovoltaischer Solarzellen ist.

Vorteilhafterweise wird bei dem erfindungsgemäßen Verfahren das Trägersubstrat unter den ortsfesten Ausgabeöffnungen hindurchbewegt. Hierdurch ist insbesondere eine einfache Integration des erfindungsgemäßen Verfahrens in einen Inline-Prozess möglich. Ebenso liegt es jedoch auch im Rahmen der Erfindung, die Ausgabeöffnungen über einem ortsfesten Trägersubstrat zu bewegen oder beide Bewegungsarten zu kombinieren. Insbesondere die Kombination beider Bewegungsarten bietet weitere Vorteile:

So kann beispielsweise das Trägersubstrat unter den Ausgabeöffnungen hindurchbewegt werden, um mehrere parallel nebeneinander angeordnete Pastenbahnen zu erzeugen, aus denen fingerartige Kontaktstrukturen entstehen. An manchen Stellen kann zusätzlich eine Bewegung der Ausgabeöffnungen erfolgen, vorteilhafterweise senkrecht zur Bewegungsrichtung des Trägersubstrates, beispielsweise um quer zu den zuvor genannten Pastenbahnen stehende mehrfach übereinander gelagerte Pastenbahnen zu erzeugen, aus denen metallische Querleitungen mit hohem Querschnitt, so genannte "Busbars" entstehen. In der vorgenannten Weise kann somit ein bei Solarzellen typisches kammartiges oder doppelkammartiges Kontaktierungsmuster erzeugt werden.

Die Entfernung zwischen Ausgabeöffnung und Substrat ist vorteilhafterweise kleiner als 5 cm, bevorzugt kleiner als 3 cm, im Weiteren bevorzugt kleiner als 1 cm, insbesondere kleiner als 0,5 cm. Hierdurch ist gewährleistet, dass der Pastenstrang zwischen Ausgabeöffnung und Trägersubstrat nicht abreist und somit eine kontinuierliche Pastenbahn auf dem Trägersubstrat erzeugt wird.

Untersuchungen des Anmelders haben ergeben, dass gewisse Vorschubgeschwindigkeiten, d. h. Relativgeschwindigkeiten zwischen Ausgabeöffnung und Trägersubstrat vorteilhaft sind. Dies ist darin begründet, dass bei Einhalten eines Mindestwertes als Relativgeschwindigkeit zwischen Trägersubstrat und Ausgabeöffnung zusätzlich eine Dehnung des aufgebrachten Pastenstranges aufgrund der höheren Geschwindigkeit der Austrittsöffnung erfolgt, so dass dünnere Pastenstränge im Vergleich zu geringeren Relativgeschwindigkeiten und insbesondere bei mehrfach übereinander Auftragen von Pastensträngen höhere Aspektverhältnisse erzielbar sind. Die Untersuchungen des Anmelders ergaben, dass vorzugsweise die Relativgeschwindigkeit zwischen Austrittsöffnung und Trägersubstrat (*vᵣₑₗ*) vorzugsweise um mindestens einen Faktor 1,4, bevorzugt mindestens um einen Faktor 2, weiter bevorzugt mindestens um einen Faktor 5 größer ist als die Geschwindigkeit *(v_{P})* mit der der Pastenstrang aus der Austrittsöffnung austritt.

Eine Optimierung wird erzielt, indem das Geschwindigkeitsverhältnis *Vᵣₑₗ*/*V_{P} in* Abhängigkeit des Durchmessers der Austrittsöffnung gewählt wird:

| Öffnungsdurchmesser der Austrittsöffnung im Bereich | Faktor *Vᵣₑₗ*/*V_{P}* mindestens | bevorzugt mindestens | insbesondere mindestens |
|---|---|---|---|
| 30 µm bis 80 µm, bevorzugt 50 µm bis 60 µm | 1 | 1,2 | 1,4 |
| 50 µm bis 100 µm, bevorzugt 70 µm bis 80 µm | 1,2 | 1,4 | 1,6 |
| 80 µm bis 150 µm, bevorzugt 110 µm bis 120 µm | 2 | 2,2 | 2,4 |
| 100 µm bis 200 µm, bevorzugt 140 µm bis 160 µm | 3 | 4 | 5 |

Um den Beginn und das Ende einer Pastenbahn auf dem Trägersubstrat zu definieren, umfasst die erfindungsgemäße Vorrichtung vorzugsweise Mittel zur Unterbrechung der Ausgabe der Paste aus den Ausgabeöffnungen. Vorzugsweise sind die Mittel derart ausgebildet, dass die Ausgabe von Paste aus einer oder mehrerer Ausgabenöffnungen wahlweise vorgebbar ist.

Vorteilhafterweise sind die vorgenannten Unterbrechungsmittel als ventilartige Shutter ausgebildet, die an einer Ausgabeöffnung oder im Flussbereich zwischen Abzweigung und Ausgabeöffnung angeordnet sind.

Ebenso liegt es im Rahmen der Erfindung, das Pumpmittel mit einer Steuereinheit zu versehen und derart steuerbar auszugestalten, dass der mittels des Pumpmittels erzeugte Druck an den Abzweigungen wahlweise vorgebbar ist, so dass durch Verlangsamung oder Ausschalten des Pumpmittels insbesondere der Druck an den Abzweigungen reduzierbar und damit die Ausgabe von Paste an den Ausgabeöffnungen abschaltbar ist.

In einer weiteren vorzugsweisen Ausführungsform der erfindungsgemäßen Vorrichtung ist im Bereich der Ausgabeöffnungen eine Saug- und/oder Blaseinrichtung angeordnet, derart, dass die ausgegebenen Pastenbahnen jeweils mittels der Saug- und/oder Blaseinrichtung abgesaugt und/oder weggeblasen werden können, so dass eine gezielte Unterbrechung des Auftragens der Pastenbahnen auf das Trägersubstrat durch Absaugen oder Wegblasen erzielbar ist.

In einer weiteren vorzugsweisen Ausführungsform der erfindungsgemäßen Vorrichtung sind die Ausgabeöffnungen beweglich angeordnet, so dass die Ausgabeöffnungen wahlweise von dem Trägersubstrat wegbewegbar und/oder wegschwenkbar sind, so dass durch Wegbewegen und/oder Wegschwenken der Ausgabeöffnungen ein Unterbrechen des Aufbringens der Pastenbahnen auf das Trägersubstrat erzielbar ist.

Vorzugsweise weist die Paste einen maximalen Partikeldurchmesser auf, der mindestens um einen Faktor 4, bevorzugt mindestens um einen Faktor 7, im Weiteren bevorzugt mindestens um einen Faktor 10 geringer ist als die minimale Querschnittsfläche im gesamten Flussweg der Paste. Hierdurch wird das Risiko einer Verstopfung weiter verringert.

Vorzugsweise ist bei der erfindungsgemäßen Vorrichtung im Umwälzbereich ein Partikelfilter vorgesehen, vorzugsweise stromabwärts der Pumpe zwischen Pumpe und den Ausgabeöffnungen angeordnet. Der Partikelfilter ist vorzugsweise derart ausgebildet, dass nur solche Partikel den Filter durchdringen können, deren Partikeldurchmesser um einen Faktor 4, bevorzugt um einen Faktor 7, im Weiteren bevorzugt um einen Faktor 10 geringer ist, als der minimale Durchmesser im Flussweg der Paste. Hierdurch wird das Risiko einer Verstopfung weiter verringert.

Bei dem erfindungsgemäßen Verfahren bzw. der erfindungsgemäßen Vorrichtung sind für die Solarzellenherstellung bekannte metallhaltige Pasten zur Herstellung einer Kontaktstruktur verwendbar, insbesondere die bei Siebdruckverfahren verwendeten Metallpartikel enthaltenden Pasten. Insbesondere ist die Verwendung von handelsüblichen Siebdruckpasten vorteilhaft.

Durch Verwendung mehrerer Umwälzkreisläufe ist es mit dem erfindungsgemäßen Verfahren und der erfindungsgemäßen Vorrichtung ebenfalls möglich, sequentiell verschiedene Medien, d. h. Pasten mit unterschiedlichen Inhaltsstoffen auf das Substrat aufzubringen, insbesondere durch in Transportrichtung des Trägersubstrates seriell angeordnete Druckeinheiten, die jeweils einen Umwälzbereich und jeweils mehrere Ausgabeöffnungen aufweisen.

Vorzugsweise ist bei der erfindungsgemäßen Vorrichtung ein Bypass vorgesehen, so dass wahlweise eine Umwälzung der Paste über den Bypass unter Umgehung der Ausgabeöffnungen erfolgen kann. Eine Umwälzung über den Bypass ist insbesondere vorteilhaft, um bei Start des Druckvorgangs eine Verflüssigung der Paste durch anfängliches Umwälzen über den Bypass zu erzielen und/oder um eine Unterbrechung der Ausgabe über die Ausgabeöffnungen durch Umgehung der Ausgabeöffnungen über den Bypass zu ermöglichen.

Bei der erfindungsgemäßen Vorrichtung ist es insbesondere vorteilhaft, dass die Druckeinheit auswechselbare Elemente umfasst, welche auswechselbaren Elemente zumindest eine Abzweigung mit einer entsprechenden Fluidleitung aufweisen, welche in einer Ausgabeöffnung münden. Hierdurch ist es somit in einfacher Weise möglich, die Ausgabeöffnungen und zugehörigen Fluidleitungen zu den Abzweigen, welche vorzugsweise als Düsen ausgebildet sind, auszuwechseln. Auf diese Weise kann beispielsweise bei verstopften Düsen schnell dadurch Abhilfe geschafft werden, dass das gesamte vorgenannte Element ausgewechselt wird. Insbesondere kann ein motorisches System vorgesehen sein, um automatisiert einen solchen Wechsel auszuführen.

Dieses motorische System kann insbesondere so ausgeführt werden, dass das auswechselbare Element während des Dispensevorgangs in der Vorschubrichtung der gesamten Vorrichtung bewegt wird. Durch diese Relativbewegung kann für jede einzelne Düse eine unterschiedliche Vorschubgeschwindigkeit erreicht werden. Dabei ist die Verbindung zur Abzweigung so auszuführen, dass während der Bewegung ein ständiger Kontakt zur Fluidleitung besteht. Dies ist vorteilhaft, da so eventuelle Unterschiede im Volumenstrom der einzelnen Ausgabeöffnungen ausgeglichen werden können.

So liegt es im Rahmen der Erfindung, eine Düsenleiste mit einer Vielzahl von Bohrungen vorzusehen, welche linear mittels eines motorischen Elementes relativ zu der Druckeinheit verschiebbar ist. Hierdurch kann in einfacher Weise eine verstopfte Düse durch Verschieben der Düsenleiste zur Position der nächsten Bohrung ersetzt werden. Ebenso ist es möglich, eine Unterbrechung des Pastenflusses zu erzielen, in dem ausgehend von einer Position mit einer Bohrung zu einer Position ohne Bohrung verschoben wird, so dass ein Verschließen des jeweiligen Pastenausgabeweges erfolgt.

Weitere vorzugsweise Merkmale und Ausgestaltungen ergeben sich anhand der Figuren und der Figurenbeschreibung. Dabei zeigt:
- Figur 1a: ein Ausführungsbeispiel einer erfindungsgemäßen Vorrichtung zur Herstellung einer metallischen Kontaktstruktur zur elektrischen Kontaktierung einer photovoltaischen Solarzelle;
- Figur 1b: ein zweites Ausführungsbeispiel einer erfindungsgemäßen Vorrichtung zur Herstellung einer metallischen Kontaktstruktur zur elektrischen Kontaktierung einer photovoltaischen Solarzelle, welches zwei Pumpmittel umfasst;
- Figur 2a: einen Querschnitt entlang der Flussrichtung der Paste durch ein erstes Ausführungsbeispiel einer Druckeinheit 4 gemäß Figur 1;
- Figuren 2b und 2c: jeweils einen Querschnitt entlang der Flussrichtung der Paste durch ein zweites und ein drittes Ausführungsbeispiel (4' und 4") einer Druckeinheit gemäß Figur 1;
- Figur 3a: einen Querschnitt der Druckeinheit gemäß Figur 2a gemäß der Linie A senkrecht zur Flussrichtung der Paste;
- Figuren 3b, 4a und 4b: jeweils Querschnitte entlang der Linie A durch alternative Ausführungsbeispiele einer Druckeinheit senkrecht zur Flussrichtung der Paste;
- Figur 5: einen Teilquerschnitt einer alternativen Ausführungsform einer Druckeinheit parallel zur Flussrichtung der Paste, bei der die Ausgabeöffnungen als Düsen ausgebildet sind;
- Figur 6: eine perspektive Darstellung der Druckeinheit gemäß Figur 2 und mehrerer Trägersubstrate;
- Figur 7: ein weiteres Ausführungsbeispiel einer erfindungsgemäßen Vorrichtung, bei dem mehrere Druckeinheiten parallel zueinander angeordnet sind;
- Figur 8a: ein weiteres Ausführungsbeispiel einer erfindungsgemäßen Vorrichtung, welches zum Ausbilden einer oszillierenden Bewegung der Paste in einem Umwälzbereich geeignet ist;
- Figur 8b: ein weiteres Ausführungsbeispiel einer erfindungsgemäßen Vorrichtung, welches sowohl das Umwälzen der Paste in einer oszillierenden Bewegung, als auch in einem Umwälzkreislauf ermöglicht und
- Figur 9: in den Teilbildern a, b und c ein weiteres Ausführungsbeispiel einer alternativen Ausführungsform einer Druckeinheit und
- Figur 10: in Teilbild a ein Düsenplättchen und in Teilbild b eine Düsenleiste zur Verwendung mit der Druckeinheit gemäß Figur 9.

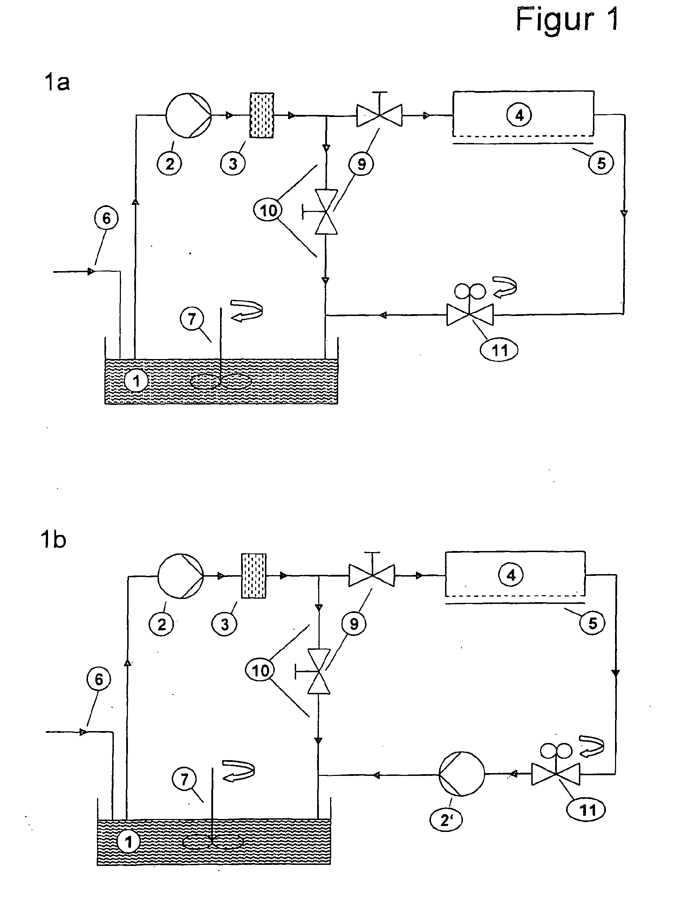

In den Figuren 1 a und 1 b sind Ausführungsbeispiele dargestellt, bei denen der Umwälzbereich jeweils als Umwälzkreislauf ausgebildet ist.

In Figur 1a ist schematisch der Grundaufbau eines ersten Ausführungsbeispiels einer erfindungsgemäßen Vorrichtung zur Herstellung einer metallischen Kontaktstruktur zur elektrischen Kontaktierung einer photovoltaischen Solarzelle dargestellt. Ausgehend von einem Pastenreservoir 1 wird Paste mittels einem als Pumpe ausgebildeten Pumpmittels 2 über einen Partikelfilter 3 in eine Druckeinheit 4 gepumpt. In der Druckeinheit 4 wird an einer Mehrzahl von Abzweigungen jeweils ein Teil der Paste abgezweigt und über jeweils den Abzweigungen zugeordneter Ausgabeöffnungen auf ein Trägersubstrat 5 aufgebracht. Das Trägersubstrat 5 stellt die Vorstufe einer aus einem Siliziumwafer herzustellenden Solarzelle dar, auf deren in Figur 1 oben liegenden Seite eine metallische Kontaktstruktur aufgebracht werden soll.

Ausgehend von der Druckeinheit fließt die Paste über eine weitere Leitung in das Pastenreservoir 1 zurück. Das Pastenreservoir 1 wird über eine Nachfüllleitung 6 nachgefüllt, sofern das Füllniveau einen vorgegebenen Mindestwert unterschreitet.

Wie in Figur 1 a ersichtlich, befindet sich die Paste bei dem Ausführungsbeispiel der erfindungsgemäßen Vorrichtung in ständiger Umwälzung: Ausgehend von dem Pastenreservoir 1 wird die Paste mittels des Pumpmittels über die Druckeinheit und von dieser weiter flussabwärts wiederum zu dem Pastenreservoir hin umgewälzt. Zusätzlich ist in dem Pastenreservoir ein Rührwerk 7 angebracht, welches zusätzlich zu einer lokalen Umwälzung innerhalb des Pastenreservoirs führt.

Die Druckeinheit 4 ist derart ausgebildet, dass im Umwälzkreislauf ausgangsseitig der Druckeinheit eine Drossel durch eine Querschnittsverjüngung ausgebildet ist. Die Pumpe 2 ist derart ausgebildet, dass druckseitig der Pumpe 2 ein Pastendruck von etwa 35 bar vorliegt. Dieser Pastendruck nimmt zwischen der Ausgangsseite der Pumpe 2 über den Partikelfilter 3 bis zur ausgangsseitig der Druckeinheit 4 angeordneten Drossel nur geringfügig (um weniger als 1 bar) ab. Stromabwärts der Druckeinheit im Rücklauf zu dem Pastenreservoir liegt hingegen ein nur geringfügig über dem Umgebungsdruck liegender Pastendruck vor. Im Pastenreservoir 1 herrscht etwa Umgebungsdruck.

Der Partikelfilter 3 ist ausgebildet, um unerwünschte Partikel, deren Durchmesser 25% des minimalen Querschnitts im gesamten Pastenkreislauf (inklusive Ausgabeöffnungen) überschreiten, auszufiltern, so dass eine Verstopfung der Ausgabeöffnungen der Druckeinheit vermieden wird.

Die Vorrichtung gemäß Figur 1 a weist weiterhin zwei Ventile 9 sowie eine Bypassleitung 10 auf. Durch Öffnen eines ersten der Ventile 9 und Schließen eines zweiten der Ventile 9 oder Unkehrung hiervon verläuft der Umwälzkreislauf der Paste wahlweise durch die Druckeinheit 4 oder durch die Bypassleitung 10. Hierdurch ist eine Unterbrechung des Auftragens von Pastenbahnen auf das Trägersubstrat 5 mittels Umschalten des Umwälzkreislaufes über die Bypassleitung 10 unter Umgehung der Druckeinheit 4 möglich.

Weiterhin ist im Umwälzkreislauf stromabwärts der Druckeinheit 4 eine regelbare Drossel 11 angeordnet, so dass zum einen über die Fördergeschwindigkeit der Pumpe 2 und zum anderen über Regelung der Drosselwirkung der Drossel 11 der Druck im Umwälzkreislauf insbesondere zwischen Pumpe 2 und Drossel 11 und somit in der Druckeinheit 4 einstellbar ist.

In Figur 1b ist schematisch der Grundaufbau eines zweiten Ausführungsbeispiels einer erfindungsgemäßen Vorrichtung zur Herstellung einer metallischen Kontaktstruktur zur elektrischen Kontaktierung einer photovoltaischen Solarzelle dargestellt. Das zweite Ausführungsbeispiel entspricht im Aufbau und der Funktion dem in Figur 1 a dargestellten Ausführungsbeispiel, wobei zusätzlich eine zweite Pumpe 2' im Umwälzkreislauf stromabwärts der Drossel 11 angeordnet ist. Hierdurch kann einerseits durch die Wahl unterschiedlicher Fördergeschwindigkeiten zwischen Pumpe 2 und Pumpe 2' zusätzlich der Druckabfall in Druckeinheit 4 gesteuert werden und darüber hinaus besteht eine geringere Gefahr der Verstopfung insbesondere der Leitungswege zwischen Druckeinheit 4 stromabwärts über Drossel 11 Pumpe 2' hin zu dem Reservoir 1, aufgrund der zusätzlichen Förderung mittels der Pumpe 2'.

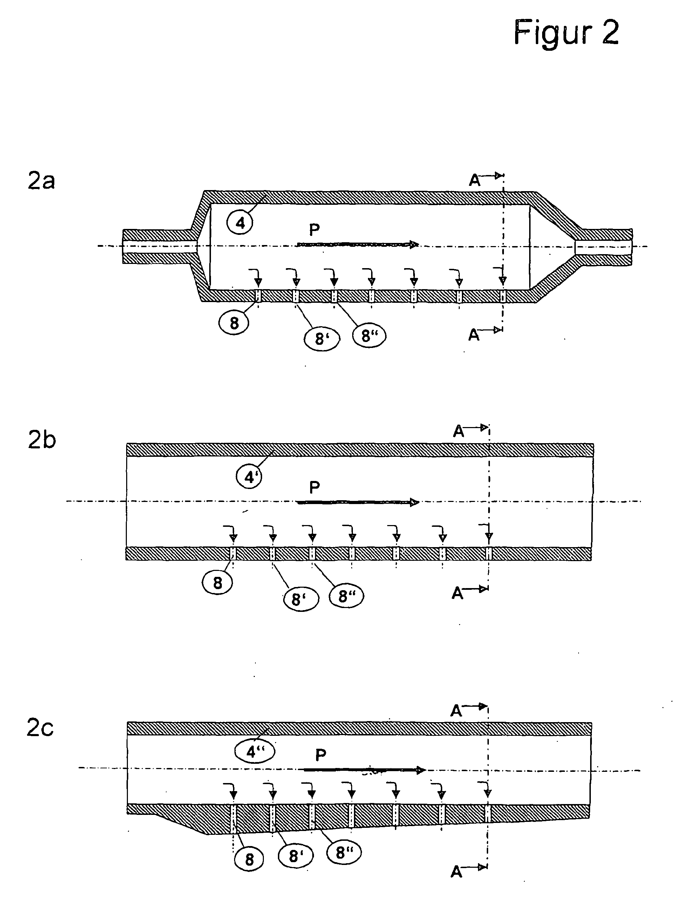

In Figur 2a ist ein Querschnitt parallel zur Flussrichtung der Paste im Umwälzkreislauf der Druckeinheit 4 dargestellt. Die Flussrichtung der Paste im Umwälzkreislauf verläuft von links nach rechts. Die Druckeinheit 4 ist als Hohlkörper ausgebildet, welcher an der Unterseite mehrere Ausnehmungen aufweist, von denen zwei exemplarisch mit den Bezugszeichen 8' und 8" gekennzeichnet sind. Die Ausnehmungen 8', 8" sind als Durchbrechungen der Außenwand der Druckeinheit 4 ausgebildet. An der in Figur 2 oberen Seite der Ausnehmungen 8', 8" wird jeweils ein Teil der Paste aus dem Umwälzkreislauf abgezweigt, durchfließt die Ausnehmungen und wird an dem in Figur 2 unten liegenden Ende der Ausnehmungen ausgegeben und somit werden mehrere Pastenbahnen auf das Trägersubstrat 5 aufgebracht. Die Ausnehmungen stellen somit im oberen Bereich Abzweigungen zum Abzweigen eines Teils der Paste aus dem Umwälzkreislauf dar, weisen im unteren Bereich jeweils eine Ausgabeöffnung zur Ausgabe der Paste dar und zwischen Abzweigung und Ausgabeöffnung dienen die Ausnehmungen als Ausgabeflussweg zwischen Abzweigung und Ausgabeöffnung.

Die Querschnittsfläche der Druckeinheit 4 im Bereich der Ausnehmungen beträgt ca. 30 mm². Stromabwärts der letzten Ausnehmung weist die Druckeinheit 4 im Bereich A eine Querschnittsverjüngung bis zu einer Querschnittsfläche ausgangsseitig der Druckeinheit 4 von 6 mm² auf. Diese Querschnittsverjüngung im Bereich A wirkt als Drossel für die Paste im Umwälzkreislauf, so dass sich die zuvor genannten Druckverhältnisse einstellen.

Die Ausnehmungen 8', 8" der Druckeinheit 4 sind zylindrisch ausgebildet mit einer Querschnittsfläche von 0,018 mm². Aufgrund der wesentlich größeren Querschnittsfläche der Druckeinheit 4 im Umwälzkreislauf der Paste, verglichen mit den Querschnittsflächen der Ausnehmungen 8', 8", beträgt der Druckabfall ausgehend von der ersten Ausnehmung 8' zu der in Flussrichtung der Paste im Umwälzkreislauf letzten Ausnehmung nur etwa 0,015 bar. An den oberen Bereichen der Ausnehmungen 8', 8", d. h. an den Abzweigungen, herrscht somit ein in etwa konstanter Druck, so dass bereits hierdurch ein in etwa gleicher Volumenstrom an den Ausgabeöffnungen der Druckeinheit 4 gewährleistet ist. Um die vorgenannte geringe Druckdifferenz zu kompensieren, ist zusätzlich die untere Umwandung der Druckeinheit 4, hinsichtlich der Wandstärke, ausgehend von der in Flussrichtung der Paste im Umwälzkreislauf ersten Ausnehmung 8', abnehmend zu der in Flussrichtung der Paste im Umwälzkreislauf letzten Ausnehmung, ausgebildet. Hierdurch ergibt sich eine kontinuierlich abnehmende Länge der Ausnehmungen. Ausnehmungen mit größerer Länge und demgemäß längerem Flussweg zwischen Abzweigung und Ausgabeöffnung weisen somit einen etwas erhöhten Durchflusswiderstand für die Paste auf, so dass der vorgenannte Druckabfall durch den mit abnehmender Länge der Ausnehmung abnehmenden Durchflusswiderstand zusätzlich kompensiert wird. Hierdurch wird mit hoher Genauigkeit an allen Ausgabeöffnungen ein gleicher Volumenstrom bei der Pastenausgabe erreicht.

In Figur 2b ist ein zweites Ausführungsbeispiel einer Druckeinheit 4' im Querschnitt parallel zur Flussrichtung der Paste im Umwälzkreislauf dargestellt. In diesem Ausführungsbeispiel weist die Druckeinheit keine Vergrößerung am Einlass bzw. Verjüngung des Durchmessers am Auslass auf, sondern ist mit dem Durchmesser der Rohrstärke des Umwälzkreislaufes ausgebildet.

In Figur 2c ist ein drittes Ausführungsbeispiel einer Druckeinheit 4 ebenfalls im Querschnitt parallel zur Flussrichtung der Paste im Umwälzkreislauf dargestellt. In diesem Ausführungsbeispiel ist die Dicke der Umwandung im Bereich der Ausnehmungen 8', 8", 8'" in Flussrichtung der Paste abnehmend ausgebildet, so dass sich der Flussweg der Paste zwischen Abzweigung aus dem Umwälzkreislauf bis zur Ausgabeöffnung verringert, d. h. der Flussweg bei Ausnehmung 8 ist größer als der bei Ausnehmung 8' und dieser wiederum größer als der bei Ausnehmung 8" etc.. Durch den abnehmenden Flussweg wird der Strömungswiderstand ebenfalls verringert und damit der Druckabfall in der Druckeinheit 4 entlang der Umwälzrichtung kompensiert.

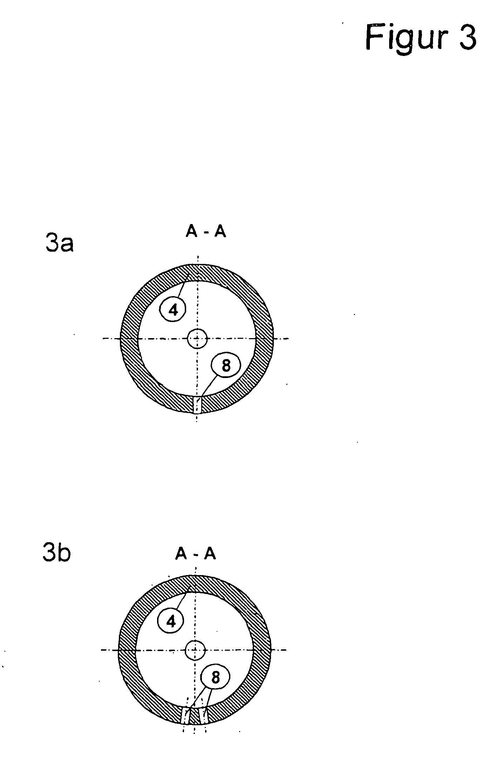

In Figur 3a ist ein Querschnitt senkrecht zur Zeichenebene in Figur 2, gemäß der Linie A dargestellt. Die Druckeinheit 4 ist als Hohlzylinder ausgebildet, wobei zumindest im Bereich der Ausnehmungen 8', 8" die Wandstärke des Hohlzylinders, wie zuvor beschrieben, in Flussrichtung der Paste im Umwälzkreisauflauf abnehmend ausgebildet ist.

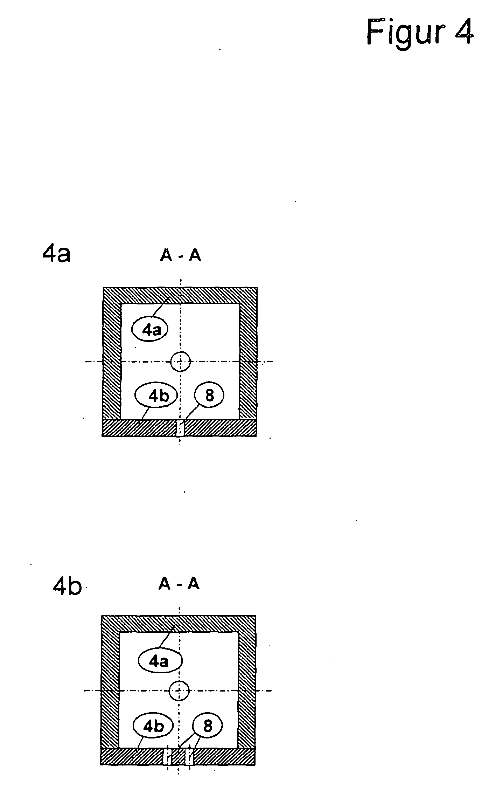

Die Figuren 3b, 4a und 4b zeigen alternative Ausführungsformen von Druckeinheiten jeweils im Querschnitt senkrecht zur Zeichenebene in Figur 2 gemäß der Linie A. In dem Ausführungsbeispiel gemäß Figur 3b sind in Umfangsrichtung der Druckeinheit jeweils zwei Ausnehmungen angeordnet, so dass nicht nur in Richtung des Umwälzkreislaufes gleichzeitig mehrere Pastenbahnen aufgetragen werden, sondern zusätzlich auch senkrecht zur Umwälzrichtung jeweils zwei Pastenbahnen gleichzeitig aufgetragen werden, beispielsweise um zwei übereinander liegende Pastenbahnen zur Erhöhung des Aspektverhältnisses zu erzeugen.

Die Figuren 4a und 4b zeigen Ausführungsformen analog zu den Figuren 3a und 3b, wobei die Druckeinheit einen rechteckigen Querschnitt aufweist. Bei Ausgestaltung der Druckeinheit 4 mit rechteckigem Querschnitt kann in einfacher Weise eine Bodenplatte, welche die Ausnehmungen 8 enthält, ausgetauscht werden, um beispielsweise bei Verstopfungen eine schnelle Abhilfe zu schaffen und/oder um für verschiedene Anwendungsgebiete unterschiedliche Anordnungen, eine unterschiedliche Anzahl und/oder eine unterschiedliche Öffnungsgröße der Ausnehmungen durch Auswahl einer entsprechenden Bodenplatte zu wählen.

In Figur 4 ist eine alternative Ausgestaltung einer Druckeinheit 4 dargestellt. Die Druckeinheit 4a ist quaderförmig ausgebildet, mit einem u-förmigen Element, welches von einer Bodenplatte 4b verschlossen wird. In der Bodenplatte 4b sind Ausnehmungen 8 ausgebildet. In dieser Ausgestaltung kann in einfacher Weise durch Austausch der Bodenplatte eine Anpassung der Ausbildung der Ausnehmungen 8, beispielsweise an unterschiedliche Pastenviskositäten, vorgenommen werden.

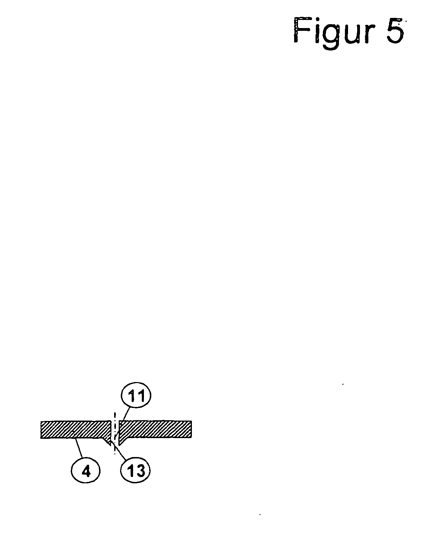

In Figur 5 ist ein weiteres Ausführungsbeispiel einer Druckeinheit 4 dargestellt, wobei lediglich ein Teilausschnitt eines Querschnittes im Bereich einer Ausnehmung 8' gezeigt ist. Die Ausnehmung 8' ist an der Außenseite der Druckeinheit 4 düsenförmig ausgebildet. Hierdurch können in einfacher Weise vorbekannte Düsengeometrien bei der erfindungsgemäßen Vorrichtung integriert werden, um spezielle Geometrien der Pastenbahnen zu erzeugen, um das Aspektverhältnis der erzeugten Pastenbahn weiter zu erhöhen.

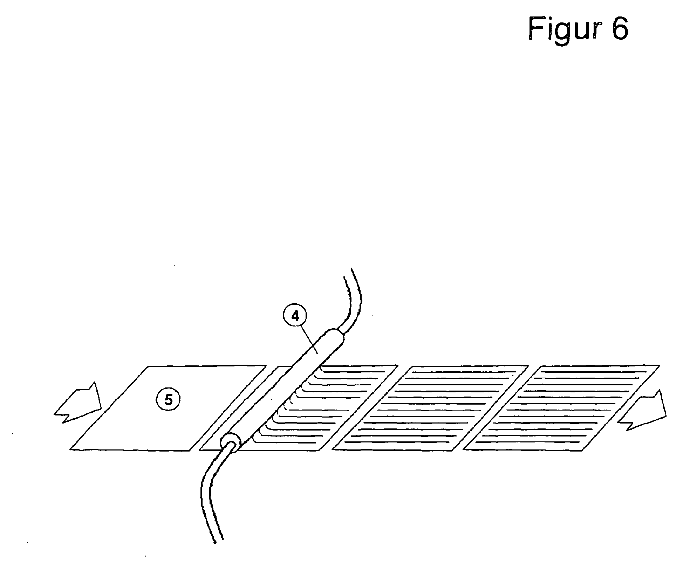

Figur 6 zeigt eine perspektivische Darstellung der Druckeinheit 4 und mehrerer Trägersubstrate 5 während der Herstellung der metallischen Kontaktstruktur.

Unterhalb der ortsfesten Druckeinheit 4 werden die Trägersubstrate 5 gemäß Richtung D hinwegbewegt. Hierdurch werden mittels der Ausnehmungen 8', 8" der Druckeinheit 4 mehrere parallele Pastenbahnen auf dem Trägersubstrat 5 erzeugt, aus welchen in weiteren Temperaturschritten die an sich bekannten fingerartigen metallischen Kontaktstrukturen auf dem Trägersubstrat 5 ausgebildet werden.

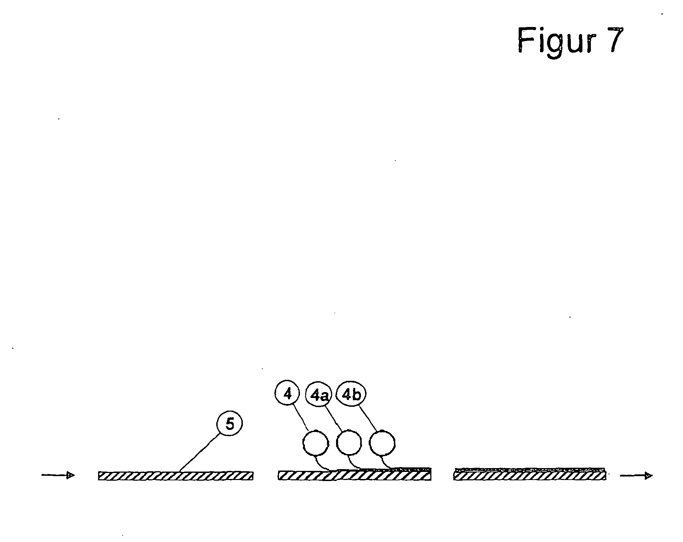

In Figur 7 ist ein weiteres Ausführungsbeispiel einer erfindungsgemäßen Vorrichtung dargestellt, bei der mehrer Druckeinheiten 4, 4a, 4b parallel zueinander angeordnet sind. Die Trägersubstrate 5 werden gemäß Richtung D bewegt und die Ausnehmungen der Druckeinheiten 4, 4a und 4b sind derart angeordnet, dass übereinander liegende Pastenbahnen erzeugt werden. Es werden somit auf dem Trägersubstrat 5 drei übereinander liegende Pastenbahnen erzeugt, so dass eine zusätzlich Erhöhung des Aspektverhältnisses erzielt wird.

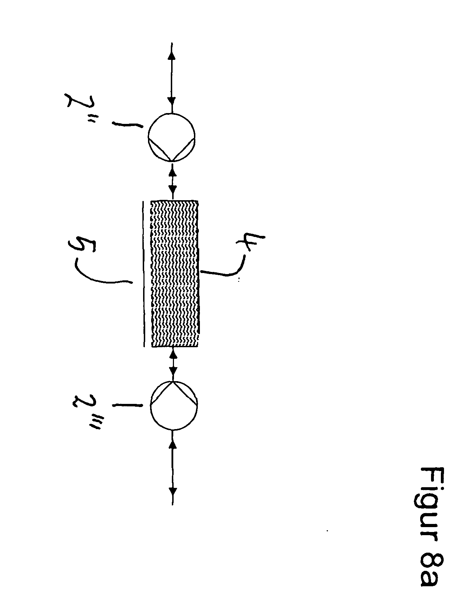

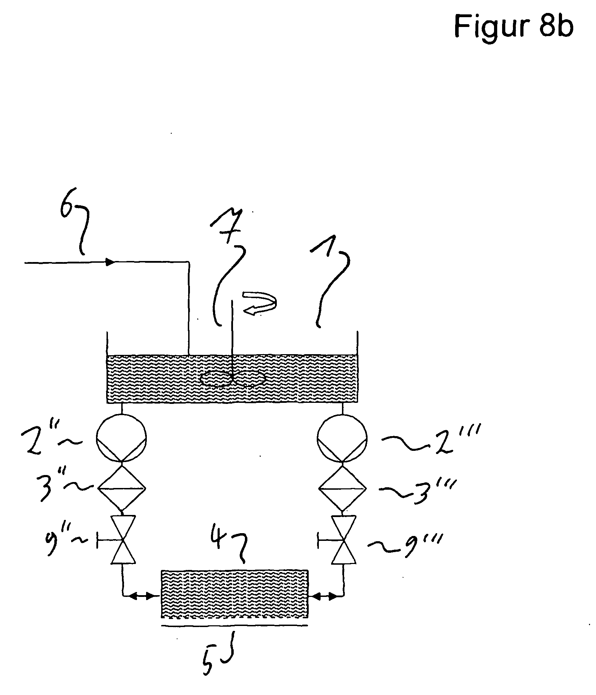

In Figur 8a ist ein weiteres Ausführungsbeispiel der erfindungsgemäßen Vorrichtung in einem Teilschemabild dargestellt. Hierbei ist der Druckeinheit 4 an jedem Ausgang jeweils ein Pumpmittel 2" und 2'" zugeordnet. Mittels dieser Pumpmittel wird die Paste in der Druckeinheit 4 oszillierend hin- und herbewegt, wie durch die Pfeile in Figur 8 gekennzeichnet.

Auf diese Weise wird ebenfalls eine ständige Bewegung der Paste und somit eine Scherbeanspruchung der Paste, welche zu einer vorteilhaften einfacheren Verarbeitung der Paste führt, erzielt.

In diesem Ausführungsbeispiel ist es somit nicht notwendig, einen geschlossenen Kreislauf auszubilden, da das Umwälzen durch eine in diesem Fall lineare oszillierende Bewegung der Paste erfolgt. Vorzugsweise sind an den jeweils der Druckeinheit 4 abgewandten Ausgängen der Pumpmittel 2" und 2'" jeweils Behältnisse zum Auffangen und/oder Nachfüllen von Paste vorgesehen.

Figur 8b zeigt ein weiteres Ausführungsbeispiel der erfindungsgemäßen Vorrichtung, welches eine Nachfüllleitung 6, ein Pastenreservoir 1 mit einem Rührwerk 7, eine Druckeinheit 4 sowie Pumpmittel 2" und 2"' umfasst. Die beiden vorgenannten Pumpmittel sind einerseits fluidleitend mit dem Pastenreservoir 1 und andererseits über Filter 3" und 3'" sowie über Ventile 9" und 9'" fluidleitend mit der Druckeinheit 4 verbunden.

In diesem Ausführungsbeispiel ist es somit möglich, eine oszillierende Hin- und Herbewegung der Paste in der Druckeinheit 4 zu erzielen. Ebenfalls ist es durch gleichsinniges Pumpen der Paste mittels der Pumpmittel 2" und 2'" möglich, die Paste in einem Umwälzkreislauf zu befördern. Durch Umkehrung des Umwälzkreisklaufs können eventuell auftretende Partikel-Ansammlungen gelöst werden.

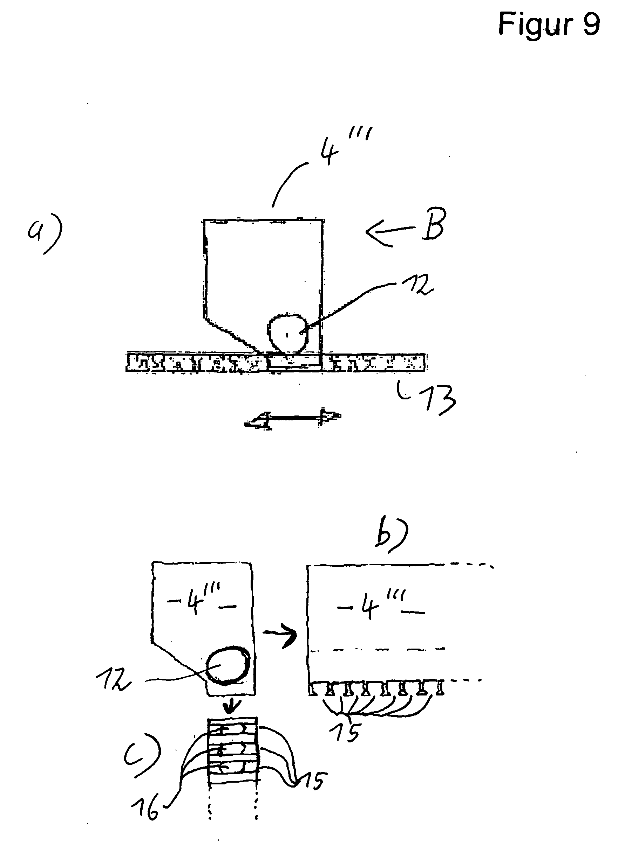

In Figur 9 ist ein weiteres alternatives Ausführungsbeispiel einer Druckeinheit 4'" dargestellt.

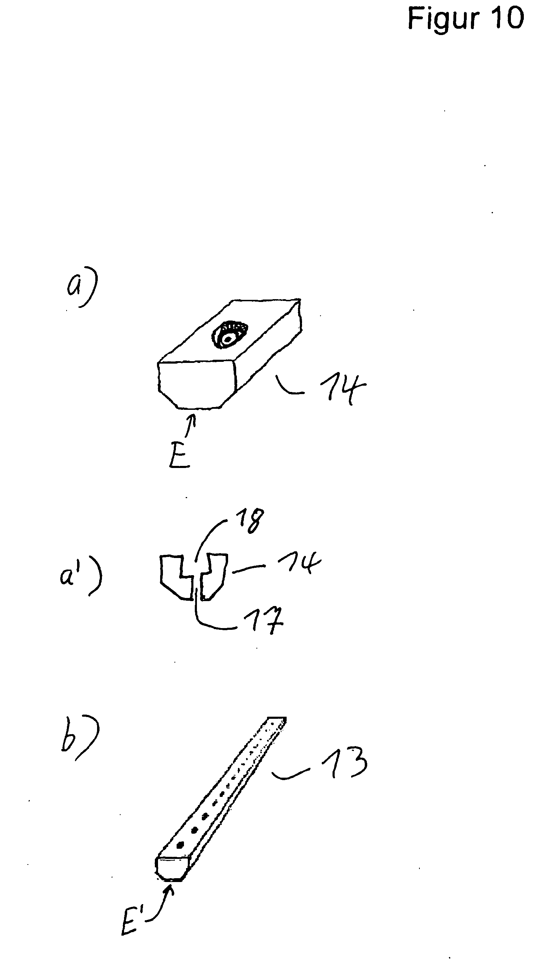

Die Druckeinheit 4"' ist in Figur 9 a im Querschnitt senkrecht zur Pastenflussrichtung dargestellt, wobei die zylinderförmige, rohrartige Pastenleitung 12 über eine verschiebbare Düsenleiste 13 mit einer entsprechenden Abzweigung und einer Auslauföffnung in diese Düsenleiste 13 fluidleitend verbunden ist. Die Düsenleiste 13 ist in Teilbild b der Figur 10 perspektivisch dargestellt. Hierbei ist die Vielzahl von Öffnungen zu sehen, welche in Abzweigungen münden die an der - nicht sichtbaren - Unterseite der Düsenleiste 13 jeweils in eine Ausgabeöffnung münden.

Mittels eines - nicht dargestellten - motorischen Verschiebemittels ist die Düsenleiste 13 in Figur 9a waagrecht verschiebbar, wie durch den Pfeil gekennzeichnet.

Hierdurch ist es somit möglich, in einfacher Weise und insbesondere auch automatisiert bei Verstopfen einer Düse durch einfaches lineares Verschieben der Düsenleiste eine neue Düse, dass heißt, eine neue Abzweigung mit Ausgabeöffnung vorzusehen. Hierdurch wird der Wartungsaufwand der erfindungsgemäßen Vorrichtung erheblich reduziert und insbesondere ist es möglich, geringere Standzeiten aufgrund von verstopften Düsen zu erzielen.

In den Teilbildern b und c der Figur 9 sind weitere Ansichten der Druckeinheit 4'" dargestellt: Figur 9b zeigt eine Seitenansicht parallel zur Flussrichtung der Paste in der rohrartigen Pastenleitung 12, d. h. eine Ansicht gemäß Pfeil B in Figur 9a und senkrecht zur Zeichenebene in Figur 9a. Hierbei sind insbesondere an der Unterseite der Druckeinheit 4'" Aufnahmen 15 ersichtlich, in welche beispielsweise jeweils eine Düsenleiste 13 gemäß Figur 10b einschiebbar ist, wobei die Schieberichtung in Figur 9b senkrecht zur Zeichenebene steht. Die Aufnahmen 15 sind komplementär zu der Querschnittsform der aufzunehmenden Düsenleisten ausgebildet, so dass die Düsenleisten formschlüssig in den Aufnahmen angeordnet werden können.

In Figur 9c ist eine Ansicht von unten auf die Druckeinheit 4'" als Teilausschnitt dargestellt. Hierbei sind in den Aufnahmen 15 jeweils Öffnungen der Druckeinheit 4"'16 ersichtlich, aus welche bei Betrieb Paste austritt und durch die entsprechenden Öffnungen in der Düsenleiste durch die jeweilige Düsenleiste hindurchtreten, um auf das (nicht dargestellte) Trägersubstrat zu gelangen.

Alternativ zur Verwendung von Düsenleisten 13 können Düsenplättchen 14 gemäß Figur 10a eingesetzt werden:

Diese Düsenplättchen weisen lediglich eine Öffnung auf und werden bei Bedarf, beispielsweise bei Verstopfung der Öffnung, ausgetauscht. Hierbei ist vorteilhafterweise ein automatischer Spender, umfassend ein Magazin mit einer Vielzahl von Düsenplättchen 14 an der Druckeinheit 4'" angeordnet, so dass wahlweise ein sich in einer vorgebbaren Aufnahme 15 befindliches Düsenplättchen durch Einschieben eines neuen Düsenplättchens 14 mittels des Spenders ausgetauscht werden kann.

Die Düsenplättchen 14 und/oder die Düsenleiste 13 können aus verschiedenen Werkstoffen hergestellt werden, vorzugsweise Werkstoffe sind Keramik, Silizium oder Stahl.

Wie insbesondere in den Figuren 9a und 9b ersichtlich, stellt das Düsenplättchen 14 bzw. die Düsenleiste 13 bei Anordnung in der Aufnahme 15 den tiefsten Punkt der Druckeinheit 4'" dar. Dies ist dadurch gewährleistet, dass das nach unten zeigende Ende (Bezugszeichen E in Figur 10a und E' in Figur 10b) des Düsenplättchens 14 bzw. der Düsenleiste 13 derart ausgebildet ist, dass es nach Einsetzen in die Aufnahme 15 nach unten hervorsteht. Dies ist bei dem in den Figuren 10a und 10b dargestellten Ausführungsbeispiel durch eine Schwalbenschwanzform des Düsenplättchens 14 und der Düsenleiste 13 im Querschnitt gewährleistet.

Vorzugsweise variieren die Düsenplättchen 14 oder verschiedene Öffnungen der Düsenleiste 13 hinsichtlich der Länge eines Düsenkanals:

In Figur 10a' ist beispielhaft ein Querschnitt durch das Düsenplättchen 14 quer zur Längserstreckung des Düsenplättchens und mittig zur Öffnung im Düsenplättchen dargestellt. Im unteren Bereich ist ein Düsenkanal 17 vorgesehen, welcher die für das gewünschte Dosierverhalten der Paste optimale Länge und den optimalen Durchmesser aufweist. Im oberen Bereich ist ein Zuführkanal 18 vorgesehen, welcher die verbleibende Höhe des Düsenplättchens 14 überbrückt und darüber hinaus einen erheblich größeren Durchmesser, verglichen mit dem Düsenkanal 17, aufweist, vorzugsweise mindestens das zweifache, bevorzugt mindestens das zehnfache des Durchmessers des Düsenkanals 17. Zuführkanal 18 und Düsenkanal 17 sind jeweils zylindrisch ausgebildet.

Hierdurch ist es möglich, bei konstanter Höhe des Düsenplättchens 14 Düsenkanäle mit unterschiedlicher Länge und unterschiedlichem Durchmesser vorzusehen, so dass das Dosierverhalten durch unterschiedliche Wahl von Länge und Durchmesser des Düsenkanals 17 variiert werden kann.

Selbstverständlich ist es ebenso möglich, bei der Düsenleiste 13 verschiedene Öffnungen gemäß dem Querschnittsbild 10a' auszubilden und insbesondere Länge und Durchmesser des jeweiligen Düsenkanals zwischen den einzelnen Öffnungen der Düsenleiste zu variieren. Hierdurch kann somit bei Verwendung der Düsenleiste 13 durch Verschieben der Düsenleiste das Dosierverhalten beeinflusst werden.

Ein Wechsel zwischen zwei Düsenplättchen 14 oder zwei verschiedenen Öffnungen der Düsenleiste 13 erfolgt vorzugsweise gleichzeitig zu dem Wechsel des zu bearbeitenden Trägersubstrates.

Vorzugsweise werden verstopfte Düsenplättchen 14 gereinigt und wieder verwendet.

## Patentansprüche

1. Verfahren zur Herstellung einer metallischen Kontaktstruktur zur elektrischen Kontaktierung einer photovoltaischen Solarzelle,
wobei zur Erzeugung der Kontaktstruktur eine Paste, welche Metallpartikel enthält, über mindestens eine Ausgabeöffnung auf eine Oberfläche eines Trägersubstrates aufgebracht wird, wobei Ausgabeöffnung und Trägersubstrat (5) während der Pastenausgabe relativ zueinander bewegt werden, **dadurch gekennzeichnet,**
**dass** die Paste in einem Umwälzbereich umgewälzt wird,
**dass** an einer Mehrzahl von Abzweigungen jeweils ein Teil der Paste aus dem Umwälzbereich abgezweigt und jeder Abzweigung mindestens eine Ausgabeöffnung zugeordnet ist, über welche die an der Abzweigung abgezweigte Paste auf die Oberfläche des Trägersubstrates aufgebracht wird, wobei die Paste jeweils zwischen der Abzweigung aus dem Umwälzbereich und Ausgabe aus der der Abzweigung zugeordneten Ausgabeöffnung einen Flussweg mit einer Länge kleiner 5 cm durchfließt.

2. Verfahren nach Anspruch 1,
**dadurch gekennzeichnet,**
**dass** das Umwälzen in dem Umwälzbereich durch ein Hin- und Herbewegen der Paste in dem Umwälzbereich, insbesondere durch eine oszillierende Pastenbewegung erfolgt.

3. Verfahren nach einem der vorangegangenen Ansprüche,
**dadurch gekennzeichnet,**
**dass** das Umwälzen in dem Umwälzbereich durch Umwälzen der Paste in einem Umwälzkreislauf erfolgt.

4. Verfahren nach einem der vorangegangenen Ansprüche,
**dadurch gekennzeichnet,**
**dass** die Paste an allen Ausgabeöffnungen mit in etwa gleichem Volumenstrom ausgegeben wird und/oder
**dass** der Volumenstrom der Paste in dem Umwälzbereich stromaufwärts einer ersten Abzweigung um mindestens um einen Faktor 5, vorzugsweise mindestens um einen Faktor 10, bevorzugt mindestens um einen Faktor 50, im Weiteren bevorzugt mindestens um einen Faktor 100, insbesondere mindestens um einen Faktor 1000 größer ist als die Summe der Volumenströme aller Ausgabeöffnungen und/oder dass in allen Teilbereichen des Umwälzbereichs, in denen sich eine Abzweigung zur Ausgabe von Paste über eine Ausgabeöffnung befindet, ein Druck von mindestens 3 bar, bevorzugt mindestens 5 bar, im Weiteren bevorzugt mindestens 10 bar, insbesondere mindestens 20 bar, weiter bevorzugt mindestens 30 bar über dem Umgebungsdruck vorliegt und/oder
**dass** der Druck der Paste an den Abzweigungen um weniger als 5%, vorzugsweise um weniger als 1%, bevorzugt um weniger als 0,5% differiert.

5. Verfahren nach einem der vorangegangenen Ansprüche,
**dadurch gekennzeichnet,**
**dass** in zumindest einem Teilbereich des Flusswegs des Umwälzbereiches Paste über mehrere in Fließrichtung der Paste hintereinander liegende Abzweigungen abgezweigt wird und ausgehend von jeder Abzweigung mindestens einer dieser Abzweigung zugeordneten Ausgabeöffnung zugeführt wird, insbesondere,
**dass** bei den in Fließrichtung der Paste im Umwälzbereich hintereinander liegenden Abzweigungen der Gesamtdruckabfall von der in Fließrichtung ersten zu der in Fließrichtung letzten Abzweigung um mindestens einen Faktor 10, bevorzugt um mindestens einen Faktor 50, insbesondere um mindestens einen Faktor 100 geringer ist als der mittlere Druckabfall zwischen Abzweigung und der Abzweigung zugeordneten Ausgabeöffnung.

6. Verfahren nach einem der vorangegangenen Ansprüche,
**dadurch gekennzeichnet,**
**dass** die Paste im Umwälzbereich zumindest in einem Teilbereich über eine Verzweigung und stromabwärts der Verzweigung in mehreren parallelen Flusswegen des Umwälzbereiches umgewälzt wird, wobei in jedem der parallelen Flusswege mindestens an einer Abzweigung ein Teil der Paste abgezweigt und über mindestens eine der Abzweigung zugeordneten Ausgabeöffnung ausgegeben wird.

7. Vorrichtung zur Herstellung einer metallischen Kontaktstruktur zur elektrischen Kontaktierung einer photovoltaischen Solarzelle mittels eines Verfahrens gemäß einem der vorangegangenen Ansprüche,
umfassend mindestens einen Ausgabeflussweg mit einer Ausgabeöffnung für eine Paste, welche Metallpartikel enthält und mindestens ein Pumpmittel (2) zur Ausgabe der Paste über den Ausgabeflussweg an der Ausgabeöffnung auf die Oberfläche eines Trägersubstrates,
**dadurch gekennzeichnet,**
**dass** die Vorrichtung einen Umwälzbereich umfasst und das Pumpmittel (2) derart mit dem Umwälzbereich zusammenwirkend ausgebildet ist, dass die Paste in dem Umwälzbereich mittels des Pumpmittels umwälzbar ist, wobei der Umwälzbereich eine Mehrzahl von Abzweigungen aufweist, welche jeweils fluidleitend über mindestens einen Ausgabeflussweg mit mindestens einer Ausgabeöffnung verbunden sind, derart, dass an den Abzweigungen jeweils ein Teil der Paste aus dem Umwälzbereich abzweigbar und über die Ausgabeöffnungen auf das Trägersubstrat (5) aufbringbar ist und
**dass** bei jeder Abzweigung die Länge des Flussweges der Paste ausgehend von der Abzweigung über die Ausgabeflusswege zu der Ausgabeöffnung kleiner 5 cm ist.

8. Vorrichtung nach Anspruch 7,
**dadurch gekennzeichnet,**
**dass** das Pumpmittel derart mit dem Umwälzbereich zusammenwirkend ausgebildet ist, dass die Paste in dem Umwälzbereich umwälzbar ist, insbesondere eine oszillierende Bewegung der Paste erzielbar ist.

9. Vorrichtung nach einem der Ansprüche 7 bis 8,
**dadurch gekennzeichnet,**
**dass** der Umwälzbereich als Umwälzkreislauf ausgebildet ist und das Pumpmittel (2) derart mit dem Umwälzkreislauf zusammenwirkend ausgebildet ist, dass die Paste in dem Umwälzkreislauf mittels des Pumpmittels umwälzbar ist.

10. Vorrichtung nach einem der Ansprüche 7 bis 9,
**dadurch gekennzeichnet,**
**dass** mindestens in einem Teilbereich des Umwälzbereiches mehrere in Fließrichtung der Paste hintereinander liegende Abzweigungen angeordnet sind, welche jeweils fluidleitend über mindestens einen Ausgabeflussweg mit mindestens einer Ausgabeöffnung verbunden sind, insbesondere, dass zwischen der Flussrichtung des Umwälzbereiches ersten und letzten Abzweigung die minimale Querschnittsfläche des Umwälzbereiches mindestens um einen Faktor 5, vorzugsweise mindestens um einen Faktor 10, bevorzugt mindestens um einen Faktor 50, im Weiteren bevorzugt mindestens um einen Faktor 100, insbesondere mindestens um einen Faktor 1000 größer ist als die minimale Querschnittsfläche aller Flusswege zwischen einer Abzweigung und der dieser Abzweigung zugeordneten Ausgabeöffnung und/oder dass bei den in Flussrichtung des Umwälzbereiches hintereinander liegenden Abzweigungen die Länge des Flussweges der Paste zwischen Abzweigung aus und Ausgabe aus der der Abzweigung zugeordneten Ausgabeöffnung in Fließrichtung des Umwälzbereiches abnimmt und/oder die minimale Querschnittsöffnung zwischen Abzweigung aus dem Umwälzbereich und Ausgabe aus der Ausgabeöffnung in Fließrichtung des Umwälzbereiches zunimmt.

11. Vorrichtung nach einem der Ansprüche 7 bis 10,
**dadurch gekennzeichnet,**
**dass** das Pumpmittel (2) stromaufwärts der Mehrzahl von Abzweigungen angeordnet ist und dass stromabwärts der in Flussrichtung letzten Abzweigung eine Drossel (11) zur Erhöhung des Durchflusswiderstandes der Paste angeordnet ist, vorzugsweise eine regelbare Drossel (11).

12. Vorrichtung nach einem der Ansprüche 7 bis 11,
**dadurch gekennzeichnet,**
**dass** zumindest im Bereich der Abzweigungen eine oder mehrere Schwingungsvorrichtungen an dem Umwälzbereich angeordnet sind, um die Paste in Schwingung zu versetzten,
insbesondere, dass die Schwingungsvorrichtung als Ultraschallgenerator zur Beaufschlagung der Paste mit Ultraschall ausgebildet ist.

13. Vorrichtung nach einem der Ansprüche 7 bis 12,
**dadurch gekennzeichnet,**
**dass** der Umwälzbereich zumindest im Bereich der Abzweigungen als Hohlkörper mit mehreren als Ausnehmungen (8) ausgebildeten Abzweigungen ausgebildet ist, insbesondere, dass die Ausnehmungen (8, 8', 8") Düsenförmig ausgebildet sind.

14. Vorrichtung nach einem der Ansprüche 7 bis 13,
**dadurch gekennzeichnet,**
**dass** im Umwälzbereich eine Heizeinrichtung zum Wärmeeintrag in die umgewälzte Paste vorgesehen ist.

15. Vorrichtung nach einem der Ansprüche 7 bis 14,
**dadurch gekennzeichnet,**
**dass** die Vorrichtung mindestens zwei Pumpmittel aufweist, die jeweils mit dem Umwälzbereich zusammenwirkend ausgebildet sind, wobei das erste Pumpmittel im Umwälzbereich stromaufwärts der ersten Abzweigung und das zweite Pumpmittel im Umwälzbereich stromabwärts der letzten Abzweigung angeordnet ist.

## Claims

1. Method of producing a metallic contact structure for electrical contacting of a photovoltaic solar cell,
wherein to create the contact structure a paste which contains metal particles is applied *via* at least one discharge opening to a surface of a carrier substrate, the discharge opening and carrier substrate (5) being moved relative to one another during the discharge of the paste,
**characterised in that**
the paste is circulated in a circulating region,
that a portion of the paste is diverted out of the circulating region at each of a plurality of branch-off points and there is associated with each branch-off point at least one discharge opening *via* which the paste that has been diverted at the branch-off point is applied to the surface of the carrier substrate,
wherein in each case the paste flows through a flowpath having a length of less than 5 cm between the point of branch-off from the circulating region and the point of discharge from the discharge opening associated with the branch-off point.

2. Method according to claim 1,
**characterised in that**
the circulation in the circulating region is effected by a back-and-forth movement of the paste in the circulating region, especially by an oscillating movement of the paste.

3. Method according to either one of the preceding claims,
**characterised in that**
the circulation in the circulating region is effected by circulation of the paste in a circulation circuit.

4. Method according to any one of the preceding claims,
**characterised in that**
the paste is discharged with an approximately identical volumetric flow rate at all discharge openings and/or
that the volumetric flow rate of the paste in the circulating region upstream of a first branch-off point is greater by at least a factor of 5, preferably by at least a factor of 10, especially by at least a factor of 50, more preferably by at least a factor of 100, more especially by at least a factor of 1000, than the sum of the volumetric flow rates of all discharge openings and/or that in all sub-regions of the circulating region in which a branch-off point for discharging paste *via* a discharge opening is located, the pressure is at least 3 bar, preferably at least 5 bar, more preferably at least 10 bar, especially at least 20 bar, more especially at least 30 bar, above the ambient pressure and/or
that the pressure of the paste at the branch-off points differs by less than 5 %, preferably by less by 1 %, especially by less than 0.5 %.

5. Method according to any one of the preceding claims,
**characterised in that**
in at least one sub-region of the flowpath of the circulating region paste is diverted *via* a plurality of branch-off points located one after the other in the flow direction of the paste and, starting from each branch-off point, is supplied to at least one discharge opening associated with that branch-off point, especially
that in the case of the branch-off points located one after the other in the flow direction of the paste in the circulating region the total drop in pressure from the first branch-off point in the flow direction to the last branch-off point in the flow direction is smaller by at least a factor of 10, preferably by at least a factor of 50, especially by at least a factor of 100, than the average drop in pressure between the branch-off point and the discharge opening associated with the branch-off point.

6. Method according to any one of the preceding claims,
**characterised in that**
in the circulating region the paste is circulated at least in a sub-region *via* a branch-off point and downstream of the branch-off point in a plurality of parallel flowpaths of the circulating region, wherein in each of the parallel flowpaths a portion of the paste is diverted at at least one branch-off point and discharged *via* at least one discharge opening associated with the branch-off point.

7. Device for the production of a metallic contact structure for electrical contacting of a photovoltaic solar cell by means of a method according to any one of the preceding claims,
comprising at least one discharge flowpath having a discharge opening for a paste which contains metal particles and at least one pump means (2) for discharging the paste *via* the discharge flowpath at the discharge opening onto the surface of a carrier substrate,
**characterised in that**
the device comprises a circulating region and the pump means (2) is arranged to co-operate with the circulating region in such a way that the paste can be circulated in the circulating region by means of the pump means,
wherein the circulating region has a plurality of branch-off points which are each in fluid-conducting connection *via* at least one discharge flowpath with at least one discharge opening in such a way that a portion of the paste can be diverted out of the circulating region at each of the branch-off points and applied *via* the discharge openings to the carrier substrate (5) and
that at each branch-off point the length of the flowpath of the paste, from the branch-off point *via* the discharge flowpaths to the discharge opening, is less than 5 cm.

8. Device according to claim 7,
**characterised in that**
the pump means is arranged to co-operate with the circulating region in such a way that the paste can be circulated in the circulating region, especially an oscillating movement of the paste being achievable.

9. Device according to either one of claims 7 and 8,
**characterised in that**
the circulating region is in the form of a circulation circuit and the pump means (2) is arranged to co-operate with the circulation circuit in such a way that the paste can be circulated in the circulation circuit by means of the pump means.

10. Device according to any one of claims 7 to 9,
**characterised in that**
at least in a sub-region of the circulating region there are arranged a plurality of branch-off points which are located one after the other in the flow direction of the paste and which are each in fluid-conducting connection *via* at least one discharge flowpath with at least one discharge opening, especially that, between the first and last branchoff points in the flow direction of the circulating region, the minimum cross-sectional area of the circulating region is greater by at least a factor of 5, preferably by at least a factor of 10, especially by at least a factor of 50, more preferably by at least a factor of 100, more especially by at least a factor of 1000, than the minimum cross-sectional area of all flowpaths between a branch-off point and the discharge opening associated with that branch-off point and/or
that in the case of the branch-off points located one after the other in the flow direction of the circulating region the length of the flowpath of the paste between the branch-off point and the point of discharge from the discharge opening associated with the branch-off point decreases in the flow direction of the circulating region and/or the minimum cross-sectional opening between the point of branch-off from the circulating region and the point of discharge from the discharge opening increases in the flow direction of the circulating region.

11. Device according to any one of claims 7 to 10,
**characterised in that**
the pump means (2) is arranged upstream of the plurality of branchoff points, and that downstream of the last branch-off point in the flow direction there is arranged a throttle (11) for increasing the throughflow resistance of the paste, preferably an adjustable throttle (11).

12. Device according to any one of claims 7 to 11,
**characterised in that**
at least in the region of the branch-off points there are arranged in the circulating region one or more oscillation devices for setting the paste in oscillation,
especially that the oscillation device is in the form of an ultrasound generator for subjecting the paste to ultrasound.

13. Device according to any one of claims 7 to 12,
**characterised in that**
the circulating region at least in the region of the branch-off points is in the form of a hollow body having a plurality of branch-off points in the form of openings (8), especially that the openings (8, 8', 8") are of nozzle-like construction.

14. Device according to any one of claims 7 to 13,
**characterised in that**
in the circulating region there is provided a heating device for introducing heat into the paste being circulated.

15. Device according to any one of claims 7 to 14,
**characterised in that**
the device has at least two pump means which are each arranged to co-operate with the circulating region, the first pump means being arranged in the circulating region upstream of the first branch-off point and the second pump means being arranged in the circulating region downstream of the last branch-off point.

## Revendications

1. Procédé de fabrication d'une structure de contact métallique pour la mise en contact électrique d'une cellule solaire photovoltaïque,
selon lequel une pâte contenant des particules métalliques est appliquée sur une surface d'un substrat de support via au moins une ouverture de distribution pour produire la structure de contact, l'ouverture de distribution et le substrat de support (5) étant déplacés l'un par rapport à l'autre pendant la distribution de la pâte,
**caractérisé en ce**
**que** la pâte est mise en circulation dans une zone de circulation,
**qu'**une partie respective de la pâte est dérivée de la zone de circulation à une pluralité de dérivations, au moins une ouverture de distribution étant associée à chaque dérivation, via laquelle la pâte dérivée à la dérivation est appliquée sur la surface du substrat de support, la pâte parcourant un chemin d'écoulement d'une longueur inférieure à 5 cm entre la dérivation de la zone de circulation et la distribution à partir de l'ouverture de distribution associée à la dérivation.

2. Procédé selon la revendication 1,
**caractérisé en ce**
**que** la mise en circulation dans la zone de circulation est réalisée par un mouvement alternatif de la pâte dans la zone de circulation, en particulier par un mouvement oscillant de la pâte.

3. Procédé selon l'une des revendications précédentes,
**caractérisé en ce**
**que** la mise en circulation dans la zone de circulation est réalisée par mise en circulation de la pâte dans un circuit de circulation.

4. Procédé selon l'une des revendications précédentes,
**caractérisé en ce**
**que** la pâte est distribuée avec à peu près le même débit volumique à toutes les ouvertures de distribution et/ou
**que** le débit volumique de la pâte dans la zone de circulation en amont d'une première dérivation est supérieur d'au moins un facteur 5, de préférence d'au moins un facteur 10, préférentiellement d'au moins un facteur 50, plus préférentiellement d'au moins un facteur 100, en particulier d'au moins un facteur 1000 à la somme des débits volumiques de toutes les ouvertures de distribution et/ou que dans toutes les zones partielles de la zone de circulation dans lesquelles se trouve une dérivation pour la distribution de pâte via une ouverture de distribution, il règne une pression d'au moins 3 bars, préférentiellement d'au moins 5 bars, plus préférentiellement d'au moins 10 bars, en particulier d'au moins 20 bars, encore plus préférentiellement d'au moins 30 bars au-dessus de la pression ambiante et/ou que la pression de la pâte aux dérivations diffère de moins de 5 %, de préférence de moins de 1 %, préférentiellement de moins de 0,5 %.

5. Procédé selon l'une des revendications précédentes,
**caractérisé en ce**
**que** dans au moins une zone partielle du chemin d'écoulement de la zone de circulation, la pâte est dérivée via plusieurs dérivations qui se succèdent dans la direction d'écoulement de la pâte et, à partir de chaque dérivation, est amenée à au moins une ouverture de distribution associée à cette dérivation, en particulier que dans les dérivations qui se succèdent dans la zone de circulation dans la direction d'écoulement de la pâte, la chute de pression totale de la première dérivation dans la direction d'écoulement à la dernière dérivation dans la direction d'écoulement est inférieure d'au moins un facteur 10, de préférence d'au moins un facteur 50, en particulier d'au moins un facteur 100 à la chute de pression moyenne entre la dérivation et l'ouverture de distribution associée à la dérivation.

6. Procédé selon l'une des revendications précédentes,
**caractérisé en ce**
**que** dans la zone de circulation, la pâte est mise en circulation au moins dans une zone partielle via une bifurcation et, en aval de la bifurcation, dans plusieurs chemins d'écoulement parallèles de la zone de circulation, une partie de la pâte étant dérivée au moins à une dérivation dans chacun des chemins d'écoulement parallèles et distribuée via au moins une ouverture de distribution associée à la dérivation.

7. Dispositif pour fabriquer une structure de contact métallique pour la mise en contact électrique d'une cellule solaire photovoltaïque au moyen d'un procédé selon l'une des revendications précédentes,
comprenant au moins un chemin d'écoulement de distribution doté d'une ouverture de distribution pour une pâte contenant des particules métalliques et au moins un moyen de pompage (2) pour, via le chemin d'écoulement de distribution, distribuer la pâte sur la surface d'un substrat de support à l'ouverture de distribution, **caractérisé en ce**
**que** le dispositif comprend une zone de circulation et le moyen de pompage (2) est conçu pour coopérer avec la zone de circulation de façon que la pâte dans la zone de circulation puisse être mise en circulation à l'aide du moyen de pompage, la zone de circulation présentant une pluralité de dérivations qui sont chacune reliées fluidiquement, via au moins un chemin d'écoulement de distribution, à au moins une ouverture de distribution, de façon qu'une partie respective de la pâte puisse être dérivée de la zone de circulation aux dérivations et appliquée sur le substrat de support (5) via les ouvertures de distribution et
**qu'**à chaque dérivation, la longueur du chemin d'écoulement de la pâte entre la dérivation et l'ouverture de distribution via les chemins d'écoulement de distribution est inférieure à 5 cm.

8. Dispositif selon la revendication 7,
**caractérisé en ce**
**que** le moyen de pompage est conçu pour coopérer avec la zone de circulation de façon que la pâte puisse être mise en circulation dans la zone de circulation, en particulier qu'un mouvement oscillant de la pâte puisse être obtenu.

9. Dispositif selon l'une des revendications 7 à 8,
**caractérisé en ce**
**que** la zone de circulation est conçue comme un circuit de circulation et le moyen de pompage (2) est conçu pour coopérer avec le circuit de circulation de façon que la pâte puisse être mise en circulation dans le circuit de circulation à l'aide du moyen de pompage.

10. Dispositif selon l'une des revendications 7 à 9,
**caractérisé en ce**
**qu'**au moins dans une zone partielle de la zone de circulation sont disposées plusieurs dérivations qui se succèdent dans la direction d'écoulement de la pâte, lesquelles sont reliées chacune fluidiquement, via au moins un chemin d'écoulement de distribution, à au moins une ouverture de distribution, en particulier qu'entre la première et la dernière dérivation dans la direction d'écoulement de la zone de circulation, la surface de section minimale de la zone de circulation est supérieure d'au moins un facteur 5, de préférence d'au moins un facteur 10, préférentiellement d'au moins un facteur 50, plus préférentiellement d'au moins un facteur 100, en particulier d'au moins un facteur 1000 à la surface de section minimale de tous les chemins d'écoulement entre une dérivation et l'ouverture de distribution associée à cette dérivation et/ou
**que** dans les dérivations qui se succèdent dans la direction d'écoulement de la zone de circulation, la longueur du chemin d'écoulement de la pâte entre dérivation et distribution à partir de l'ouverture de distribution associée à la dérivation diminue dans la direction d'écoulement de la zone de circulation et/ou l'ouverture de section minimale entre dérivation de la zone de circulation et distribution à partir de l'ouverture de distribution augmente dans la direction d'écoulement de la zone de circulation.

11. Dispositif selon l'une des revendications 7 à 10,
**caractérisé en ce**
**que** le moyen de pompage (2) est disposé en amont de la pluralité de dérivations et qu'en aval de la dernière dérivation dans la direction d'écoulement est disposé un étranglement (11) pour augmenter la résistance de passage de la pâte, de préférence un étranglement réglable (11).

12. Dispositif selon l'une des revendications 7 à 11,
**caractérisé en ce**
**qu'**au moins dans la zone des dérivations, un ou plusieurs dispositifs vibratoires sont disposés sur la zone de circulation pour faire vibrer la pâte,
en particulier que le dispositif vibratoire est réalisé sous la forme d'un générateur d'ultrasons destiné à soumettre la pâte à des ultrasons.

13. Dispositif selon l'une des revendications 7 à 12,
**caractérisé en ce**
**que** la zone de circulation est réalisée, au moins dans la zone des dérivations, sous la forme d'un corps creux pourvu de plusieurs dérivations réalisées sous la forme d'évidements (8), en particulier que les évidements (8, 8', 8") sont réalisés en forme de buse.

14. Dispositif selon l'une des revendications 7 à 13,
**caractérisé en ce**
**qu'**un dispositif de chauffage pour apporter de la chaleur à la pâte mise en circulation est prévu dans la zone de circulation.

15. Dispositif selon l'une des revendications 7 à 14,
**caractérisé en ce**
**que** le dispositif présente au moins deux moyens de pompage qui sont conçus chacun pour coopérer avec la zone de circulation, le premier moyen de pompage étant disposé dans la zone de circulation en amont de la première dérivation et le deuxième moyen de pompage en aval de la dernière dérivation dans la zone de circulation.
